# EUROPEAN PATENT APPLICATION

(11) **EP 4 368 037 A1**
(43) Date of publication of application: **15.05.2024**
(21) Application number: 21949346.7
(22) Date of filing: 08.07.2021
(51) Int. Cl.: A24F 40/40

(54) **POWER SUPPLY UNIT FOR AEROSOL GENERATION DEVICE**

(71) Applicant: Japan Tobacco, Inc., Tokyo, 105-6927 (JP)
(72) Inventor: KITAHARA Minoru, Tokyo 130-8603 (JP); TANAKA Shujiro, Tokyo 130-8603 (JP); ONO Yasuhiro, Tokyo 130-8603 (JP)
(74) Representative: Hoffmann Eitle
(86) International application number: PCT/JP2021/025829
(87) International publication number: WO 2023/281713

(57) **Abstract**

A power supply unit (10) comprises: a battery (BAT); a discharge terminal (41) which is connected to a heater (21) that generates aerosols from an aerosol source by consuming electricity supplied from the battery (BAT); a DC/DC converter (63) which includes a VIN pin connected to the battery (BAT) and a VOUT pin connected to the discharge terminal (41); a capacitor (Cd61) and a capacitor (Cd63) which are connected between the discharge terminal (41) and the VOUT pin of the DC/DC converter; and an MCU mounting substrate (7) which has the DC/DC converter (63), the capacitor (Cd63), and the capacitor (Cd61) mounted thereon. The capacitors (Cd63, Cd61) are so disposed as not to align in the longitudinal or the width direction of the MCU mounting substrate (7).

## Description

### TECHNICAL FIELD

The present invention relates to a power supply unit of an aerosol generating device.

### BACKGROUND ART

In an aerosol generating device including a load for generating aerosol from an aerosol source by consuming electric power supplied from a power supply, when the electric power supplied to the load becomes unstable, the amount of aerosol generated by the load varies, and a fragrance taste is reduced. Patent Literature 1 discloses a technique in which a plurality of capacitors are provided as smoothing capacitors on an output side of a first DC-DC converter that supplies electric power to a load.

### CITATION LIST

### PATENT LITERATURE

Patent Literature 1: JP6833093B

### SUMMARY OF INVENTION

### TECHNICAL PROBLEM

In the related art, a mounting position on a circuit substrate of a plurality of capacitors connected to an output terminal of a voltage converter has not been sufficiently considered, and there is room for improvement in the mounting position. When the mounting position of the capacitors is not appropriate, the circuit substrate may be increased in size to mount the capacitors.

The present invention provides a power supply unit of an aerosol generating device capable of avoiding an increase in size of a circuit substrate while mounting a plurality of capacitors connected to an output terminal of a voltage converter on the circuit substrate.

### SOLUTION TO PROBLEM

A power supply unit of an aerosol generating device, includes:
a power supply;
a connector to which a load configured to generate aerosol from an aerosol source by consuming electric power supplied from the power supply, or a coil configured to transmit electric power to the load by electromagnetic induction is connected;
a voltage converter that has an input terminal connected to the power supply and an output terminal connected to the connector;
a first capacitor and a second capacitor connected between the output terminal of the voltage converter and the connector; and
a circuit substrate on which the voltage converter, the first capacitor, and the second capacitor are mounted, in which
the first capacitor and the second capacitor are not arranged in a line in a length direction or a width direction of the circuit substrate.

### ADVANTAGEOUS EFFECTS OF INVENTION

According to the present invention, it is possible to provide a power supply unit of an aerosol generating device capable of avoiding an increase in size of a circuit substrate while mounting a plurality of capacitors connected to an output terminal of a voltage converter on the circuit substrate.

### BRIEF DESCRIPTION OF DRAWINGS

[FIG. 1] FIG. 1 is a perspective view of an aerosol inhalation device 1.
[FIG. 2] FIG. 2 is another perspective view of the aerosol inhalation device 1.
[FIG. 3] FIG. 3 is a cross-sectional view of the aerosol inhalation device 1.
[FIG. 4] FIG. 4 is a perspective view of a power supply unit 10.
[FIG. 5] FIG. 5 is an exploded perspective view of the power supply unit 10.
[FIG. 6] FIG. 6 is a diagram showing a circuit configuration of the power supply unit 10.
[FIG. 7] FIG. 7 is a perspective view of the power supply unit 10 from which a case 11 is removed.
[FIG. 8] FIG. 8 is a diagram showing a main surface-side surface layer 71a of an MCU mounting substrate 7.
[FIG. 9] FIG. 9 is a diagram showing a second wiring layer 74a of the MCU mounting substrate 7.
[FIG. 10] FIG. 10 is a diagram showing a sub surface-side surface layer 71b of the MCU mounting substrate 7.
[FIG. 11] FIG. 11 is a diagram showing a fourth wiring layer 74b of the MCU mounting substrate 7.
[FIG. 12] FIG. 12 is a diagram showing a positional relation between the MCU mounting substrate 7 and a discharge terminal 41.
[FIG. 13] FIG. 13 is a cross-sectional view of the MCU mounting substrate 7.
[FIG. 14] FIG. 14 is an enlarged view of the periphery of an end portion on an X1 direction side of the main surface-side wiring layer 74a of the MCU mounting substrate 7 shown in FIG. 9.
[FIG. 15] FIG. 15 is an enlarged view of a wiring pattern 77_Ln6a shown in FIG. 14.
[FIG. 16] FIG. 16 is an enlarged view of a wiring pattern 77_Ln6b shown in FIG. 14.

### DESCRIPTION OF EMBODIMENTS

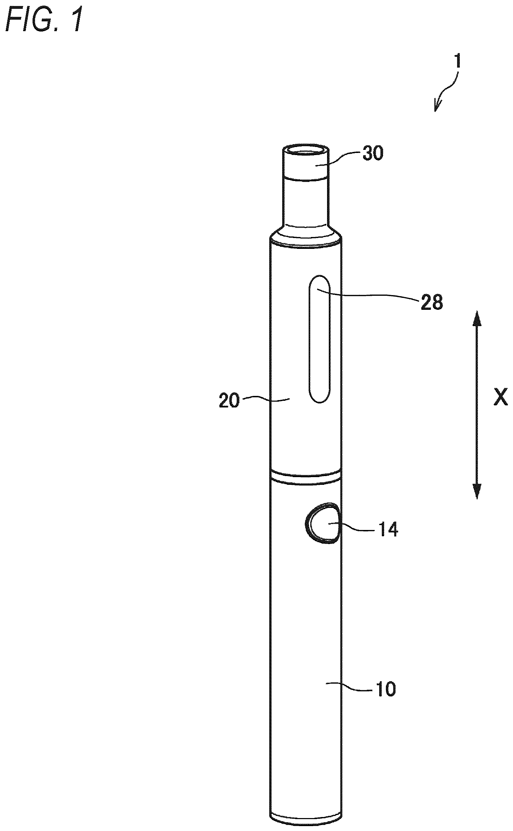

Hereinafter, a power supply unit of an aerosol generating device according to an embodiment of the present invention will be described, and first, the aerosol generating device (hereinafter, referred to as an aerosol inhalation device) to which the power supply unit is attached will be described with reference to FIGs. 1 to 3.

### (Aerosol Inhalation Device)

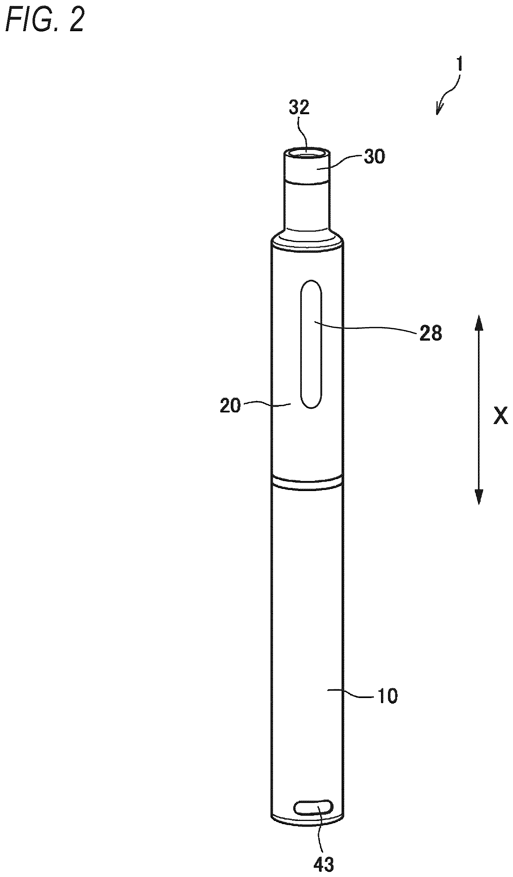

An aerosol inhalation device 1 is a device for suctioning aerosol with flavor added without combustion, and has a rod shape extending along a predetermined direction (hereinafter, referred to as an X direction). As shown in FIGs. 1 and 2, the aerosol inhalation device 1 is provided with a power supply unit 10, a first cartridge 20, and a second cartridge 30 in this order along the X direction. The first cartridge 20 may be attachable to and detachable from the power supply unit 10, and the second cartridge 30 may be attachable to and detachable from the first cartridge 20. In other words, the first cartridge 20 and the second cartridge 30 are replaceable with respect to the power supply unit 10. The second cartridge 30 is replaceable with respect to the first cartridge 20. The first cartridge 20 may be fitted and fixed to the power supply unit 10 so that a user cannot easily attach and detach the first cartridge 20.

### (Power Supply Unit)

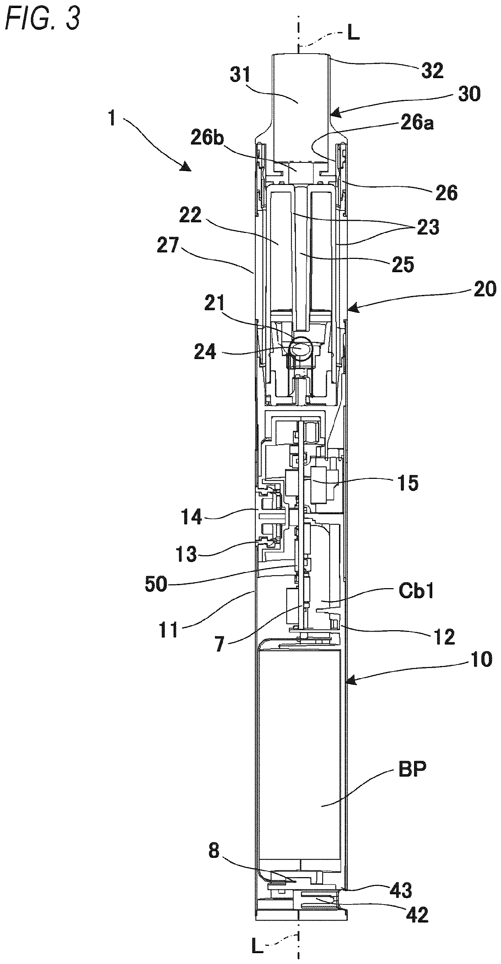

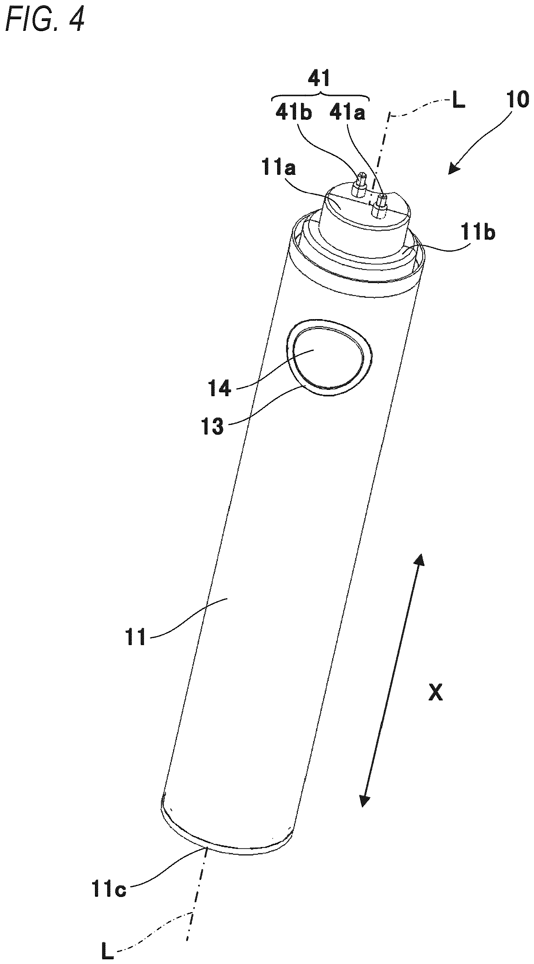

As shown in FIGs. 3 to 5 and 7, the power supply unit 10 of the present embodiment accommodates a battery pack BP, a micro controller unit (MCU) 50, an MCU mounting substrate 7, a receptacle mounting substrate 8, and the like in a cylindrical case 11.

A power supply BAT accommodated in the battery pack BP is a rechargeable secondary battery, an electric double layer capacitor, and the like, and is preferably a lithium ion secondary battery. An electrolyte of the power supply BAT may include one or a combination of a gel electrolyte, an electrolyte solution, a solid electrolyte, and an ionic liquid.

A discharge terminal 41 is provided on a top portion 11a located on one end side (first cartridge 20 side) of the case 11 in the X direction. The discharge terminal 41 includes a positive electrode-side discharge terminal 41a and a negative electrode-side discharge terminal 41b. In the present specification, a "positive electrode side" means a higher potential side than a "negative electrode side". In other words, the "negative electrode side" means a lower potential side than the "positive electrode side". Therefore, in the following description, the term "positive electrode side" may be read as a "high potential side", and the term "negative electrode side" may be read as a "low potential side".

The positive electrode-side discharge terminal 41a and the negative electrode-side discharge terminal 41b protrude from the top portion 11a toward the first cartridge 20, and are electrically connectable to a heater 21 of the first cartridge 20. In the case 11, a low floor portion 11b is provided around the top portion 11a.

A charging opening 43 (see FIG. 2) for allowing access to a charging terminal 42 is provided in a peripheral wall portion on a bottom portion 11c side, a bottom portion 11c being located on the other end side of the case 11 (side opposite to the first cartridge 20) in the X direction. The charging terminal 42 is electrically connected to an external power supply such as an outlet or a mobile battery to receive electric power supply, is a universal serial bus (USB) Type-C receptacle in the present embodiment, but is not limited thereto. The charging opening 43 may be provided in a bottom surface on the bottom portion 11c side instead of the peripheral wall portion on the bottom portion 11c side.

The charging terminal 42 may include, for example, a power receiving coil, and may wirelessly receive the electric power transmitted from the external power supply. A wireless power transfer method in this case may be an electromagnetic induction type, a magnetic resonance type, or a combination of the electromagnetic induction type and the magnetic resonance type. In addition, as another example, the charging terminal 42 may be connected to various USB terminals or the like, and may include the power receiving coil. With such a configuration, the chances of charging the power supply BAT may be increased.

In the case 11, an operation unit 14 that is operable by the user is provided on the peripheral wall portion of the top portion 11a so as to face a side opposite to the charging opening 43. The operation unit 14 is implemented by a button-type switch, and is used, for example, to activate and deactivate the MCU 50 and various sensors in accordance with a use intention of the user. The operation unit 14 may be implemented by a touch panel or the like.

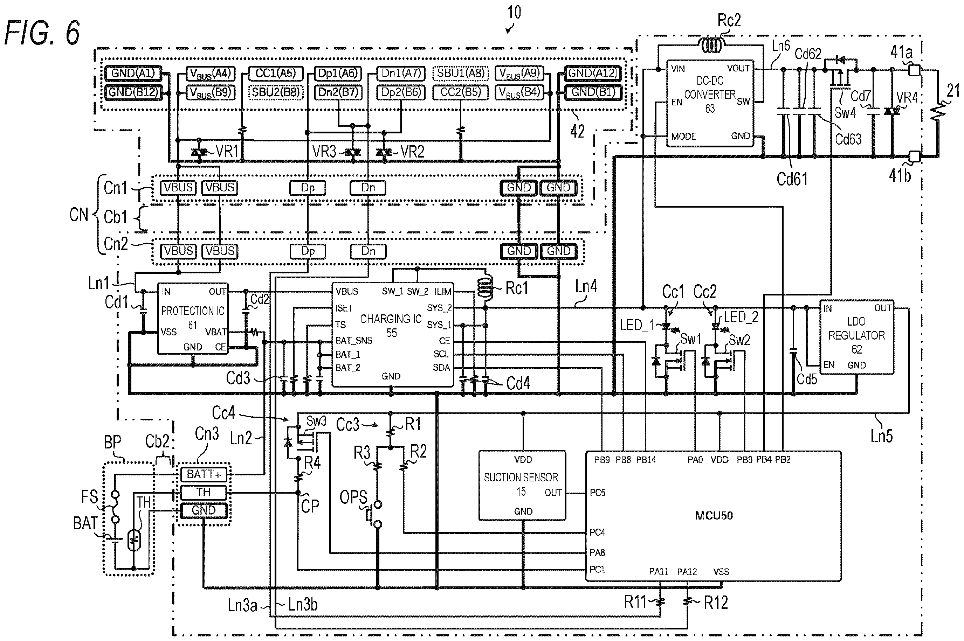

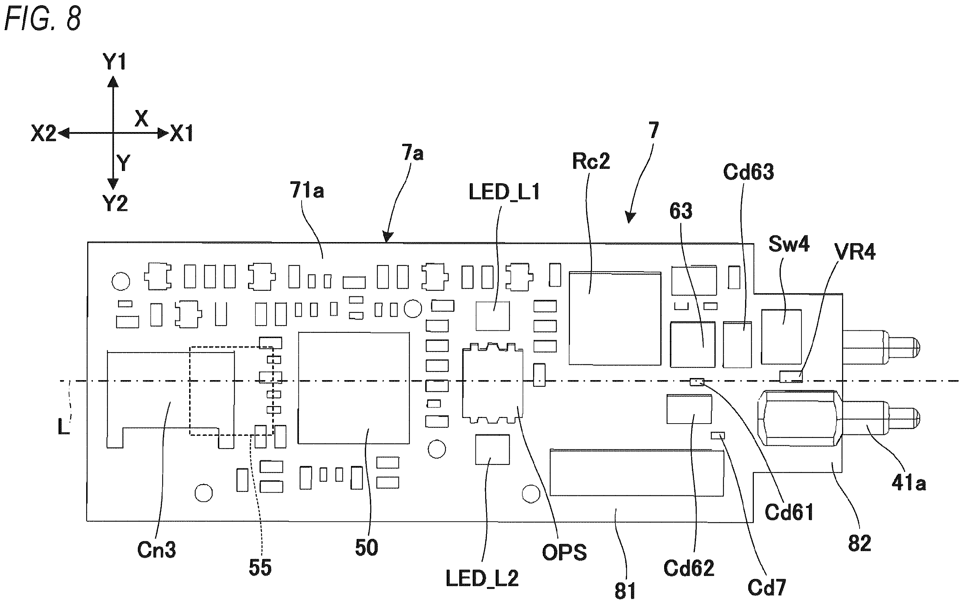

The aerosol inhalation device 1 is provided with a notification unit that notifies various types of information. The notification unit may be implemented by a light emitting element, a vibration element, or a sound output element. In addition, the notification unit may be a combination of two or more of the light emitting element, the vibration element, and the sound output element. The notification unit may be provided in any of the power supply unit 10, the first cartridge 20, and the second cartridge 30, and is preferably provided in the power supply unit 10 in order to shorten a conductive wire (that is, a wiring distance) from the power supply BAT. The notification unit of the present embodiment includes an LED window 13 provided around the operation unit 14, and an LED_L1 and an LED L2 (see FIGs. 6 and 8) to be described later.

An internal configuration of the power supply unit 10 will be described later.

### (First Cartridge)

As shown in FIG. 3, the first cartridge 20 includes, in a cylindrical cartridge case 27, a reservoir 23 that stores an aerosol source 22, the heater 21 that atomizes and/or vaporizes (hereinafter, simply referred to as "atomizes") the aerosol source 22, a wick 24 that draws the aerosol source from the reservoir 23 to the heater 21, an aerosol flow path 25 through which aerosol generated by atomizing the aerosol source 22 flows toward the second cartridge 30, and an end cap 26 that accommodates a part of the second cartridge 30.

The reservoir 23 is partitioned to surround the aerosol flow path 25 and stores the aerosol source 22. The reservoir 23 may accommodate a porous body such as a resin web or cotton, and the aerosol source 22 may be impregnated in the porous body. The reservoir 23 may store only the aerosol source 22 without accommodating the porous body on the resin web or the cotton. The aerosol source 22 contains a liquid such as glycerin, propylene glycol, and water. An amount of the aerosol source 22 stored in the reservoir 23 may be visually confirmed through a remaining amount confirmation window 28 (see FIGs. 1 and 2) provided in the first cartridge 20. A gap (not shown), which is an air intake port is formed between the remaining amount confirmation window 28 and the cartridge case 27, and outside air is taken into the cartridge case 27 through the gap. The air intake port is not necessarily provided around the remaining amount confirmation window 28. For example, a gap may be formed between the operation unit 14 and the LED window 13 provided in the power supply unit, and outside air may be taken into the case 11 through the gap, or the charging opening 43 may be used. In addition, a communication hole may be provided in a wall surface of the cartridge case 27 or a wall surface of the case 11 to communicate the inside and the outside.

The wick 24 is a liquid holding member that draws the aerosol source 22 from the reservoir 23 to the heater 21 using capillary action, and is formed of, for example, glass fiber or porous ceramic.

The heater 21 atomizes the aerosol source 22 by electric power supplied from the power supply BAT via the discharge terminal 41 without combustion. The heater 21 is implemented by a heating wire (coil) wound at a predetermined pitch. The heater 21 is an example of a load capable of generating aerosol by atomizing the aerosol source 22, and the load is, for example, a heating element or an ultrasonic generator. Examples of the heating element include a heating resistor, a ceramic heater, and an induction heating heater.

The aerosol flow path 25 is provided downstream of the heater 21 and on a center line L of the power supply unit 10 (case 11). The center line L is a line continuously connecting center points of the power supply unit 10 (case 11) in the X direction when the power supply unit 10 (case 11) is cut along a plane orthogonal to the X direction.

The end cap 26 includes a cartridge accommodating portion 26a that accommodates a part of the second cartridge 30, and a communication passage 26b that communicates the aerosol flow path 25 with the cartridge accommodating portion 26a.

### (Second Cartridge)

The second cartridge 30 stores a flavor source 31. The second cartridge 30 is detachably accommodated in the cartridge accommodating portion 26a provided in the end cap 26 of the first cartridge 20. The second cartridge 30 has a suction port 32 for the user at an end portion on a side opposite to the first cartridge 20 side. The suction port 32 is not limited to being integrated with the second cartridge 30, and may be attachable to and detachable from the second cartridge 30. By providing the suction port 32 separately from the power supply unit 10 and the first cartridge 20 in this way, the suction port 32 may be kept hygienically.

The second cartridge 30 passes the aerosol generated by atomizing the aerosol source 22 with the heater 21 through the flavor source 31 to impart flavor to the aerosol. As a raw material piece constituting the flavor source 31, it is possible to use a molded product obtained by molding a shredded tobacco or a tobacco raw material into granules. The flavor source 31 may be formed of plants other than tobacco (for example, mint, Chinese medicine, and herb). The flavor source 31 may contain a fragrance such as menthol.

In the aerosol inhalation device 1 of the present embodiment, the aerosol with added flavor may be generated by the aerosol source 22, the flavor source 31, and the heater 21. That is, the aerosol source 22 and the flavor source 31 may be referred to as aerosol generating sources that generate aerosol.

A configuration of the aerosol generating sources used in the aerosol inhalation device 1 may include a configuration in which the aerosol source 22 and the flavor source 31 are separately provided, a configuration in which the aerosol source 22 and the flavor source 31 are integrally provided, a configuration in which the flavor source 31 is omitted and a substance that may be contained in the flavor source 31 is added to the aerosol source 22, a configuration in which a drug or the like is added to the aerosol source 22 instead of the flavor source 31, and the like.

In the aerosol inhalation device 1 configured in this way, the heater 21 atomizes the aerosol source 22 drawn or moved from the reservoir 23 by the wick 24. The aerosol generated by the atomization flows through the aerosol flow path 25 together with air flowing in from the gap (not shown), which is the air intake port formed between the remaining amount confirmation window 28 and the cartridge case 27, and is supplied to the second cartridge 30 via the communication passage 26b. The aerosol supplied to the second cartridge 30 is flavored by passing through the flavor source 31, and is supplied to the suction port 32.

### (Circuit Configuration of Power Supply Unit 10)

Next, a circuit configuration of the power supply unit 10 will be described with reference to FIG. 6.

In FIG. 6, electronic components illustrated within a range surrounded by a one-dot chain line are electronic components mounted on the receptacle mounting substrate 8. That is, the receptacle mounting substrate 8 includes, as main electronic components, the charging terminal 42 which is the receptacle into which a USB Type-C plug (hereinafter, also simply referred to as a USB plug) may be inserted, and a receptacle mounting substrate-side connector Cn1 to which one end of a substrate connection cable Cb1 that connects the receptacle mounting substrate 8 and the MCU mounting substrate 7 is connected. In the present embodiment, the substrate connection cable Cb1 is a flexible printed circuit (FPC) cable having six printed patterns, but is not limited thereto. The battery connection cable Cb2 may be connected by three wires.

In FIG. 6, electronic components illustrated within a range surrounded by a two-dot chain line are electronic components mounted on the MCU mounting substrate 7. That is, the MCU mounting substrate 7 includes, as main electronic components, an MCU mounting substrate-side connector Cn2 to which the other end of the substrate connection cable Cb1 is connected, the MCU 50 that performs overall control of the aerosol inhalation device 1 including the power supply unit 10, a charging integrated circuit (IC) 55 that performs charging of the power supply BAT or the like, a protection IC 61 that protects the charging IC 55, a low dropout (LDO) regulator 62 that supplies a predetermined voltage to the MCU 50 or the like, a suction sensor 15 that detects a puff (suction) operation of the user, the discharge terminal 41 (41a, 41b) to which the heater 21 is connected, a DC-DC converter 63 that may supply electric power to the discharge terminal 41, and a battery connector Cn3 to which a battery connection cable Cb2 that connects the battery pack BP and the MCU mounting substrate 7 is connected.

The MCU 50, the charging IC 55, the protection IC 61, the LDO regulator 62, the suction sensor 15, and the DC-DC converter 63 are implemented by, for example, chipping a plurality of circuit elements, and are provided with pins as terminals for electrically connecting the inside and the outside of the chipped electronic components. The details of the pins provided in the chipped electronic components will be described later. It should be noted that in the present specification or the like, only main pins among the pins provided in the chipped electronic components are described.

The battery pack BP includes the power supply BAT, a fuse FS connected to a positive electrode terminal of the power supply BAT, and a thermistor TH connected to a negative electrode terminal of the power supply BAT and disposed close to the power supply BAT. The thermistor TH mainly includes an element having a negative temperature coefficient (NTC) characteristic or a positive temperature coefficient (PTC) characteristic, that is, an element having a correlation between an electric resistance value and a temperature. In addition, in the present embodiment, the battery connection cable Cb2 that connects the battery pack BP and the MCU mounting substrate 7 is an FPC cable having three printed patterns, but is not limited thereto. The battery connection cable Cb2 may be connected by three wires.

In FIG. 6, wiring indicated by a thick solid line is wiring connected to a ground provided in the power supply unit 10 (for example, wiring implemented by a ground pattern 78 or the like to be described later). That is, the wiring has the same potential as a reference potential (ground potential) in the power supply unit 10, and is hereinafter also referred to as a ground line.

The power supply unit 10 is provided with a VBUS line Ln1, a VBAT line Ln2, a D+ line Ln3a, a D- line Ln3b, a power-path line Ln4, a VSYS line Ln5, and a VHEAT line Ln6 as main wiring other than the ground line. Each line (wiring) mainly includes a conductive pattern formed on the MCU mounting substrate 7. The electronic components connected to the lines will be described later.

Hereinafter, the substrate connection cable Cb1, the receptacle mounting substrate-side connector Cn1, and the MCU mounting substrate-side connector Cn2, which are electronic components connecting the receptacle mounting substrate 8 and the MCU mounting substrate 7, are collectively referred to as a substrate connection portion CN.

### (Charging Terminal and Protection IC)

The charging terminal 42 includes pins (terminals) connected to an A1 pin, anA4 pin, anA5 pin, anA6 pin, anA7 pin, an A8 pin, an A9 pin, an A12 pin, a B1 pin, a B4 pin, a B5 pin, a B6 pin, a B7 pin, a B8 pin, a B9 pin, and a B12 pin of the inserted USB plug. In the present specification or the like, the pins of the charging terminal 42 corresponding to the An pins (n = 1 to 12) of the USB plug are also referred to as the An pins of the charging terminal 42. Similarly, the pins of the charging terminal 42 corresponding to the Bn pins of the USB plug are also referred to as the Bn pins of the charging terminal 42.

The A1 pin, the A12 pin, the B1 pin, and the B12 pin of the charging terminal 42 corresponding to GND (ground) pins of the USB plug are connected to the ground line.

The A4 pin, the A9 pin, the B4 pin, and the B9 pin of the charging terminal 42 corresponding to VBUS pins of the USB plug are connected to a VBUS pin, which is a power supply terminal on a high potential side of the charging IC 55, via the substrate connection portion CN, the VBUS line Ln1, and the protection IC 61. Accordingly, electric power (for example, USB bus power) input from the external power supply to the power supply unit 10 via the pin A4, the pin A9, the pin B4, or the pin B9 of the charging terminal 42 may be supplied to the charging IC 55, and the electric power may be used to charge the power supply BAT or be supplied to the MCU 50 by the charging IC 55.

The protection IC 61 provided between the charging terminal 42 and the charging IC 55 will be described in detail. The protection IC 61 includes an IN pin which is a power supply terminal on a high potential side, a VSS pin which is a power supply terminal on a low potential side, a grounded GND pin, an OUT pin which is an output terminal to which a first system voltage Vs1 to be described later is output, a CE pin for turning on and off the protection IC 61 (hereinafter, also referred to as on and off), and a VBAT pin for detecting a connection state of the power supply BAT.

The A4 pin and the B9 pin, and the A9 pin and the B4 pin of the charging terminal 42 are connected in parallel to the IN pin of the protection IC 61 via the substrate connection portion CN and the VBUS line Ln1. In other words, the IN pin of the protection IC 61 is connected to the A4 pin and the B9 pin, and the A9 pin and the B4 pin of the charging terminal 42, respectively. The VSS pin, the GND pin, and the CE pin of the protection IC 61 are connected to the ground line. The OUT pin of the protection IC 61 is connected to the VBUS pin of the charging IC 55. The VBAT pin of the protection IC 61 is connected to the positive electrode terminal (that is, high potential side) of the power supply BAT via the VBAT line Ln2, the battery connector Cn3, the battery connection cable Cb2, and the fuse FS. The negative electrode terminal (that is, low potential side) of the power supply BAT is connected to the ground line via the battery connection cable Cb2 and the battery connector Cn3.

The protection IC 61 operates when a power supply voltage is supplied based on a difference between a potential of the IN pin and a potential of the VSS pin, and an input to the CE pin is a low level, outputs the predetermined first system voltage Vs1 from the OUT pin or detects whether the power supply BAT is connected based on a voltage input to the VBAT pin. The charging IC 61 in the present embodiment is enabled by inputting the low level to the CE pin, and thus operates in negative logic. Alternatively, the positive logic protection IC 61 that is enabled by inputting a high level to the CE pin may be used. In this case, the CE pin is preferably connected to the IN pin so that the high level is input to the CE pin.

More specifically, when the USB plug is inserted into the charging terminal 42 and a USB cable including the USB plug is connected to the external power supply, a predetermined USB voltage (for example, 5 [V]) is supplied from the external power supply to the A4 pin, the A9 pin, the B4 pin, and the B9 pin of the charging terminal 42. Accordingly, the USB voltage is supplied to the protection IC 61 as the power supply voltage. In addition, the CE pin of the protection IC 61 is grounded, and thus a voltage input to the CE pin is normally the low level. Therefore, the protection IC 61 outputs the first system voltage Vs1 to the charging IC 55 in response to the supply of the USB voltage from the external power supply via the charging terminal 42.

The first system voltage Vs1 output by the protection IC 61 has a voltage value included in a range of a recommended input voltage of the charging IC 55 (for example, a range of 4.35 to 6.4 [V]).

For example, when the voltage input to the IN pin (in other words, the potential of the IN pin) is included in the range of the recommended input voltage of the charging IC 55, the protection IC 61 outputs the voltage input to the IN pin as it is as the first system voltage Vs1 from the OUT pin. On the other hand, when the voltage input to the IN pin exceeds a maximum value of the recommended input voltage of the charging IC 55, the protection IC 61 converts the voltage input to the IN pin into a predetermined voltage (for example, 5.5 ± 0.2 [V]) included in the range of the recommended input voltage of the charging IC 55, and outputs the converted voltage as the first system voltage Vs1 from the OUT pin. Accordingly, even when a high voltage exceeding the maximum value of the recommended input voltage of the charging IC 55 is input to the protection IC 61, it is possible to prevent the high voltage from being output from the protection IC 61 to the charging IC 55 and to protect the charging IC 55 from the high voltage.

When a high voltage exceeding the maximum value of the recommended input voltage of the charging IC 55 is input to the IN pin, the protection IC 61 may prevent the high voltage input to the IN pin from being output from the OUT pin by opening a circuit (not shown) in the protection IC 61 that connects the IN pin and the OUT pin.

As described above, the protection IC 61 may detect whether the power supply BAT is connected based on the voltage input to the VBAT pin. The protection IC 61 may use, in the protection IC 61, a detection result of whether the power supply BAT is connected, or may output the detection result to the outside (for example, the MCU 50 or the charging IC 55) of the protection IC 61. Further, the protection IC 61 may have various protection functions for protecting an electric circuit of the power supply unit 10, such as an overcurrent detection function and an overvoltage detection function, in addition to the above-described function for protecting the charging IC 55.

As shown in FIG. 6, a capacitor Cd1 for stabilizing (smoothing) the input to the IN pin of the protection IC 61 (also referred to as a smoothing capacitor or a bypass capacitor) is appropriately connected to the VBUS line Ln1 as necessary. Similarly, a capacitor Cd2 for stabilizing the input to the VBUS pin of the charging IC 55 (that is, the first system voltage Vs1 output from the protection IC 61) is appropriately connected between the OUT pin of the protection IC 61 and the VBUS pin of the charging IC 55 as necessary.

The A4 pin, the A9 pin, the B4 pin, and the B9 pin of the charging terminal 42 that are connected to the IN pin of the protection IC 61 are also connected to the ground line via a varistor (variable resistor: non-linear resistance element) VR1. In this way, by connecting the A4 pin, the A9 pin, the B4 pin, and the B9 pin of the charging terminal 42 to the ground line via the varistor VR1, even when static electricity is generated at the A4 pin, the A9 pin, the B4 pin, or the B9 pin of the charging terminal 42 due to rubbing or the like when the USB plug is inserted into the charging terminal 42, the static electricity may be released to the ground line via the varistor VR1. Therefore, the protection IC 61 may be protected from the static electricity generated at the A4 pin, the A9 pin, the B4 pin, or the B9 pin of the charging terminal 42.

The A6 pin and the B6 pin of the charging terminal 42 corresponding to a Dp (also referred to as D+) 1 pin or a Dp2 pin of the USB plug are connected to a PA 11 pin of the MCU 50 via the substrate connection portion CN and the D+ line Ln3a. The A7 pin and the B7 pin of the charging terminal 42 corresponding to a Dn (also referred to as D-) 1 pin or a Dp2 pin of the USB plug are connected to a PA12 pin of the MCU 50 via the substrate connection portion CN and the D- line Ln3b. Accordingly, it is possible to perform serial communication using, for example, two signal lines, i.e., the D+ line Ln3a and the D- line Ln3b between the MCU 50 and an external device (hereinafter, also simply referred to as an external device) to which the USB cable including the USB plug inserted into the charging terminal 42 is connected. A communication method other than serial communication may be adopted for communication between the external device and the MCU 50.

The A6 pin and the B6 pin of the charging terminal 42 connected to the PA11 pin of the MCU 50 are also connected to the ground line via a varistor VR2. Accordingly, even when static electricity is generated at the A6 pin or the B6 pin of the charging terminal 42, the static electricity may be released to the ground line via the varistor VR2. Therefore, the MCU 50 may be protected from the static electricity generated at the A6 pin or the B6 pin of the charging terminal 42.

As shown in FIG. 6, when a resistor R11 is provided between the A6 pin and the B6 pin of the charging terminal 42, and the PA11 pin of the MCU 50, the resistor R11 may prevent a large current from being input to the PA11 pin of the MCU 50. In the present specification or the like, the resistor is an element that is implemented by a resistance element, a transistor, or the like and has a predetermined electric resistance value.

The A7 pin and the B7 pin of the charging terminal 42 connected to the PA12 pin of the MCU 50 are also connected to the ground line via a varistor VR3. Accordingly, even if static electricity is generated at the A7 pin or the B7 pin of the charging terminal 42, the static electricity may be released to the ground line via the varistor VR3. Therefore, the MCU 50 may be protected from the static electricity generated at the A7 pin or the B7 pin of the charging terminal 42.

As shown in FIG. 6, when a resistor R12 is provided between the A7 pin and the B7 pin of the charging terminal 42, and the PA12 pin of the MCU 50, the resistor R12 may prevent a large current from being input to the PA12 pin of the MCU 50.

In the power supply unit 10, there is no problem even when the MCU 50 does not recognize whether the USB plug is inserted into the charging terminal 42 in an upside-up direction or an upside-down direction. Therefore, the A5 pin and the B5 pin of the charging terminal 42 corresponding to a CC1 pin or a CC2 pin of the USB plug are connected to the ground line. Further, the A8 pin and the B8 pin of the charging terminal 42 corresponding to an SBU1 pin or an SBU2 pin of the USB plug are not connected to the electric circuit of the power supply unit 10. That is, the pins of the charging terminal 42 are not used in the power supply unit 10, and thus the pins may be omitted as appropriate. In this way, it is possible to prevent the circuit configuration of the power supply unit 10 from becoming complicated.

### (Charging IC)

The charging IC 55 includes the VBUS pin which is one of the power supply terminals on the high potential side, a GND pin which is a power supply terminal on a low potential side, a BAT_1 pin and a BAT_2 pin which are input and output terminals used for transmitting and receiving electric power between the charging IC 55 and the power supply BAT, a BAT SNS pin which is a detection terminal for detecting an input to the power supply BAT or an output from the power supply BAT, an SYS_1 pin, an SYS_2 pin, an SW_1 pin, and an SW_2 pin which are output terminals from which a second system voltage Vs2 to be described later is output, and a CE pin for turning on and off the charging IC 55. The pin BAT_1 and the pin BAT_2 may also function as power supply terminals on the high potential side of the charging IC 55.

As described above, the VBUS pin of the charging IC 55 is connected to the OUT pin of the protection IC 61. The BAT_1 pin, the BAT_2 pin, and the BAT SNS pin of the charging IC 55 are connected to the positive electrode terminal of the power supply BAT via the VBAT line Ln2, the battery connector Cn3, the battery connection cable Cb2, and the fuse FS. The SYS_1 pin, the SYS_2 pin, the SW_1 pin, and the SW_2 pin of the charging IC 55 are connected to an IN pin which is a power supply terminal on a high potential side of the LDO regulator 62 and a VIN pin which is a power supply terminal on a high potential side of the DC-DC converter 63 via the power-path line Ln4. The SW_1 pin and the SW_2 pin are connected to the power-path line Ln4 via a reactor Rc1. In addition, the CE pin of the charging IC 55 is connected to a PB14 pin of the MCU 50.

The charging IC 55 operates when a power supply voltage is supplied based on a difference between a potential of the VBUS pin, the BAT_1 pin, or the BAT_2 pin and a potential of the GND pin and an input to the CE pin is a high level, charges the power supply BAT or supplies the electric power discharged from the power supply BAT to the LDO regulator 62, the DC-DC converter 63, or the like. The charging IC 55 in the present embodiment is enabled by inputting the high level to the CE pin, and thus operates in positive logic. Alternatively, the negative logic charging IC 55 that is enabled by inputting a low level to the CE pin may be used.

More specifically, when the first system voltage Vs1 is input to the VBUS pin, the charging IC 55 outputs a voltage (for example, the first system voltage Vs1) for charging the power supply BAT to the power supply BAT from the BAT_1 pin and the BAT 2 pin. On the other hand, when the power supply BAT is discharged, an output voltage (terminal voltage) of the power supply BAT is input to the BAT _1 pin and the BAT 2 pin. In this case, the charging IC 55 outputs the second system voltage Vs2 corresponding to the voltage input to the BAT_1 pin and the BAT 2 pin to the LDO regulator 62, the DC- DC converter 63, or the like from the SYS_1 pin, the SYS_2 pin, the SW_1 pin, and the SW_2 pin. The second system voltage Vs2 is, for example, the output voltage of the power supply BAT, and specifically, may be a voltage of about 3 to 4 [V].

The charging IC 55 further includes an SCL pin connected to a PB8 pin of the MCU 50 and an SDA pin connected to a PB9 pin of the MCU 50. Accordingly, for example, inter-integrated circuit (I2C) communication may be performed between the charging IC 55 and the MCU 50. Using the communication, the charging IC 55 transmits, for example, battery information related to the power supply BAT to the MCU 50. The battery information is, for example, information indicating a charging state (for example, charging or charging stopped) of the power supply BAT by the charging IC 55, a remaining amount (SOC: State of Charge) of the power supply BAT, or the like. A communication method other than the I2C communication may be adopted for communication between the charging IC 55 and the MCU 50.

As shown in FIG. 6, the charging IC 55 may further include an ISET pin, an ILIM pin, a TS pin, and the like. When the charging IC 55 includes the ISET pin, a current value output from the charging IC 55 to the power supply BAT may be set based on an electric resistance value of a resistor connected between the ISET pin and the ground line. When the charging IC 55 includes the ILIM pin, an upper limit of a current value output from the charging IC 55 to the LDO regulator 62, the DC-DC converter 63, or the like may be set based on an electric resistance value of a resistor connected between the ILIM pin and the ground line. When the charging IC 55 includes the TS pin, the charging IC 55 may detect an electric resistance value or a temperature of a resistor connected to the TS pin based on a voltage input to the TS pin.

As shown in FIG. 6, a capacitor Cd3 for stabilizing an input to the BAT_SNS pin of the charging IC 55 or the like is appropriately connected to the VBAT line Ln2 as necessary. In addition, a capacitor Cd4 for stabilizing the second system voltage Vs2 output from the charging IC 55 and a capacitor Cd5 for stabilizing an input to the IN pin of the LDO regulator 62 are appropriately connected to the power-path line Ln4 as necessary.

### (LED Circuit)

A first LED circuit Cc1 for operating (for example, lighting) the LED L1 and a second LED circuit Cc2 for operating the LED L2 are further connected to the power-path line Ln4 to which the second system voltage Vs2 output from the charging IC 55 is supplied.

The first LED circuit Cc1 is implemented by connecting the LED L1 and a switch Sw1 that switches between conduction and interruption of the first LED circuit Cc1 in series. The first LED circuit Cc1 has one end connected to the power-path line Ln4, and the other end connected to the ground line. In addition, the switch Sw1 of the first LED circuit Cc1 is turned on in response to an ON command from the MCU 50, and is turned off in response to an OFF command from the MCU 50. When the switch Sw1 is turned on, the first LED circuit Cc1 becomes conductive, and the second system voltage Vs2 output from the charging IC 55 is supplied to the LED L1 to light the LED L1.

For example, a switch implemented by a MOSFET may be adopted as the switch Sw1. In the present embodiment, as an example, a gate terminal of the MOSFET constituting the switch Sw1 is connected to a PA0 pin of the MCU 50, and the MCU 50 controls an output from the PA0 pin to change a gate voltage applied to the gate terminal of the switch Sw1, thereby turning on or off the switch Sw1. The switch Sw1 is not limited to the MOSFET, and may be any switch that is turned on and off under the control of the MCU 50.

The second LED circuit Cc2 is implemented by connecting the LED L2 and a switch Sw2 that switches between conduction and interruption of the second LED circuit Cc2 in series. The second LED circuit Cc2 has one end connected to the power-path line Ln4, and the other end connected to the ground line. In addition, the switch Sw2 of the second LED circuit Cc2 is turned on in response to an ON command from the MCU 50, and is turned off in response to an OFF command from the MCU 50. When the switch Sw2 is turned on, the second LED circuit Cc2 becomes conductive, and the second system voltage Vs2 output from the charging IC 55 is supplied to the LED L2 to light the LED L2.

Similar to the switch Sw1, for example, a switch implemented by a MOSFET may be adopted as the switch Sw2. In the present embodiment, as an example, a gate terminal of the MOSFET constituting the switch Sw2 is connected to a PB3 pin of the MCU 50, and the MCU 50 controls an output from the PB3 pin to change a gate voltage applied to the gate terminal of the switch Sw2, thereby turning on or off the switch Sw2. The switch Sw2 is not limited to the MOSFET, and may be any switch that is turned on and off under the control of the MCU 50.

### (LDO Regulator)

The LDO regulator 62 includes the IN pin which is the power supply terminal on the high potential side, a GND pin which is a power supply terminal on a low potential side, an OUT pin which is an output terminal from which a third system voltage Vs3 to be described later is output, and an EN pin for turning on and off the LDO regulator 62.

As described above, the IN pin of the LDO regulator 62 is connected to the SYS_1 pin, the SYS_2 pin, and the like of the charging IC 55 via the power-path line Ln4. The GND pin of the LDO regulator 62 is connected to the ground line. The OUT pin of the LDO regulator 62 is connected to a VDD pin which is a power supply terminal on a high potential side of the MCU 50 and a VDD pin which is a power supply terminal on a high potential side of the suction sensor 15 via the VSYS line Ln5. The EN pin of the LDO regulator 62 is connected to the power-path line Ln4.

The LDO regulator 62 operates when a power supply voltage is supplied based on a difference between a potential of the IN pin and a potential of the GND pin and a voltage input to the EN pin is a high level, generates the predetermined third system voltage Vs3, and outputs the predetermined third system voltage Vs3 from the OUT pin. The LDO regulator 62 in the present embodiment is enabled by inputting the high level to the EN pin, and thus operates in positive logic. Alternatively, the positive logic LDO regulator 62 that is enabled by inputting a low level to the EN pin may be used. In this case, the EN pin is preferably connected to the ground line so that the low level is normally input to the EN pin.

More specifically, in response to the charging IC 55 outputting the second system voltage Vs2, the LDO regulator 62 is supplied with the second system voltage Vs2 as a power supply voltage. In addition, when the charging IC 55 outputs the second system voltage Vs2, the voltage input to the EN pin of the LDO regulator 62 becomes the second system voltage Vs2 (that is, high level). Therefore, when the charging IC 55 outputs the second system voltage Vs2, the LDO regulator 62 generates the third system voltage Vs3 and outputs the generated third system voltage Vs3 to the MCU 50, the suction sensor 15, or the like.

The third system voltage Vs3 output by the LDO regulator 62 has a voltage value suitable for operating the MCU 50, the suction sensor 15, or the like. Specifically, the third system voltage Vs3 is a voltage smaller than the second system voltage Vs2, and may be, for example, 2.5 [V].

### (Operation Switch Circuit)

An operation switch circuit Cc3 for detecting a user operation on an operation switch OPS and a power supply temperature detection circuit Cc4 for detecting a temperature of the power supply BAT are further connected to the VSYS line Ln5 to which the third system voltage Vs3 output from the LDO regulator 62 is supplied.

The operation switch circuit Cc3 includes a resistor R1, a resistor R2, a resistor R3, and the operation switch OPS. The resistor R1 has one end connected to the VSYS line Ln5 and the other end connected to one end of each of the resistors R2 and R3. In addition, the other end of the resistor R2 is connected to a PC4 pin of the MCU 50, and the other end of the resistor R3 is connected to one end of the operation switch OPS. The other end of the operation switch OPS is connected to the ground line.

When the operation switch OPS is not operated by the user, the PC4 pin of the MCU 50 receives a voltage obtained by stepping down the third system voltage Vs3 supplied to the VSYS line Ln5 by the resistors R1 and R2. On the other hand, when the operation switch OPS is operated by the user, the PC4 pin of the MCU 50 receives a voltage obtained by dividing the third system voltage Vs3 supplied to the VSYS line Ln5 by the resistors R1 and R3 and stepping down the same by the resistor R2. Therefore, the MCU 50 may detect the presence or absence of the user operation on the operation switch OPS based on the voltage input to pin PC4.

### (Power Supply Temperature Detection Circuit)

The power supply temperature detection circuit Cc4 is implemented by connecting the thermistor TH, a resistor R4, and a switch Sw3 that switches between conduction and interruption of the power supply temperature detection circuit Cc4 in series. One end of the power supply temperature detection circuit Cc4 on a switch Sw3 side is connected to the VSYS line Ln5, and the other end of the power supply temperature detection circuit Cc4 on a thermistor TH side is connected to the ground line. In addition, a PC1 pin of the MCU 50 is connected to a connection point CP between the resistor R4 and the thermistor TH in the power supply temperature detection circuit Cc4.

The switch Sw3 of the power supply temperature detection circuit Cc4 is turned on in response to an ON command from the MCU 50, and is turned off in response to an OFF command from the MCU 50. When the switch Sw3 is turned on, the power supply temperature detection circuit Cc4 becomes conductive, and a voltage obtained by dividing the third system voltage Vs3 supplied to the VSYS line Ln5 by an electric resistance value of the resistor R4 and an electric resistance value of the thermistor TH is input to the PC1 pin of the MCU 50. As described above, the thermistor TH has a correlation between the electric resistance value and a temperature, and thus a voltage input to the PC1 pin when the switch Sw3 is turned on changes depending on the temperature of the thermistor TH. Therefore, the MCU 50 may detect the temperature of the thermistor TH (that is, the temperature of the power supply BAT) based on the voltage input to the PC1 pin when the switch Sw3 is turned on.

Similar to the switch Sw1 or the like, for example, a switch implemented by a MOSFET may be adopted as the switch Sw3. In the present embodiment, as an example, a gate terminal of the MOSFET constituting the switch Sw3 is connected to a PA8 pin of the MCU 50, and the MCU 50 controls an output from the PA8 pin to change a gate voltage applied to the gate terminal of the switch Sw3, thereby turning on or off the switch Sw3. The switch Sw3 is not limited to the MOSFET, and may be any switch that is turned on and off under the control of the MCU 50.

### (DC-DC Converter)

The DC-DC converter 63 includes the VIN pin which is the power supply terminal on the high potential side, a GND pin which is a power supply terminal on a low potential side, a SW pin to which a voltage is input, a VOUT pin which is an output terminal from which a fourth system voltage Vs4 to be described later is output, an EN pin for turning on and off the DC-DC converter 63, and a MODE pin for setting an operation mode of the DC-DC converter 63.

As described above, the VIN pin of the DC-DC converter 63 is connected to the SYS_1 pin, the SYS_2 pin, and the like of the charging IC 55 via the power-path line Ln4. The GND pin of the DC-DC converter 63 is connected to the ground line. The SW pin of the DC-DC converter 63 is connected to the power-path line Ln4 via a reactor Rc2. The VOUT pin of the DC-DC converter 63 is connected to the positive electrode-side discharge terminal 41a which is a positive electrode terminal (that is, high potential side) of the discharge terminal 41 via the VHEAT line Ln6. The EN pin of the DC-DC converter 63 is connected to a PB2 pin of the MCU 50. The MODE pin of the DC-DC converter 63 is connected to the power-path line Ln4. In addition, the negative electrode-side discharge terminal 41b which is a negative electrode terminal (that is, low potential side) of the discharge terminal 41 is connected to the ground line.

The DC-DC converter 63 operates when a power supply voltage is supplied based on a difference between a potential of the VIN pin and a potential of the GND pin and a voltage input to the EN pin is a high level, boosts the input voltage, and outputs the boosted voltage from the VOUT pin. The DC-DC converter 63 in the present embodiment is enabled by inputting the high level to the EN pin, and thus operates in positive logic. Alternatively, the negative logic DC-DC converter 63 that is enabled by inputting a low level to the EN pin may be used.

More specifically, in response to the charging IC 55 outputting the second system voltage Vs2, the DC-DC converter 63 is supplied with the second system voltage Vs2 as a power supply voltage. In addition, the MCU 50 inputs a high-level voltage signal to the EN pin of the DC-DC converter 63 when determining to heat the heater 21 in response to an aerosol generation request (for example, puff operation of the user) or the like. Accordingly, the DC-DC converter 63 outputs the fourth system voltage Vs4 obtained by boosting the voltage input to the DC-DC converter 63 to the discharge terminal 41 (that is, the heater 21).

The fourth system voltage Vs4 output from the DC-DC converter 63 has a voltage value suitable for heating the heater 21. Specifically, the fourth system voltage Vs4 is a voltage larger than the third system voltage Vs3, and may be, for example, about 4.2 [V].

The DC-DC converter 63 is, for example, a switching regulator, and may take a pulse width modulation mode (hereinafter, also referred to as a PWM mode) and a pulse frequency modulation mode (hereinafter, also referred to as a PFM mode) as operation modes. In the present embodiment, by connecting the MODE pin of the DC-DC converter 63 to the power-path line Ln4, the DC-DC converter 63 is operated in the PWM mode so that a voltage input to the MODE pin when the DC-DC converter 63 may operate becomes a high level.

As shown in FIG. 6, the VHEAT line Ln6 is provided with a switch Sw4 that switches between conduction and interruption of the VHEAT line Ln6. The switch Sw4 is turned on in response to an ON command from the MCU 50, and is turned off in response to an OFF command from the MCU 50. When the switch Sw4 is turned on, the VHEAT line Ln6 becomes conductive, and the fourth system voltage Vs4 output from the DC-DC converter 63 is supplied to the discharge terminal 41 (specifically, the positive electrode-side discharge terminal 41a) to heat the heater 21. Accordingly, an aerosol source may be atomized or vaporized to generate aerosol.

For example, a switch implemented by a MOSFET may be adopted as the switch Sw4. More specifically, the switch Sw4 is preferably a power MOSFET having a high switching speed. In the present embodiment, as an example, a gate terminal of the MOSFET constituting the switch Sw4 is connected to a PB4 pin of the MCU 50, and the MCU 50 controls an output from the PB4 pin to change a gate voltage applied to the gate terminal of the switch Sw4, thereby turning on or off the switch Sw4.

### (Another Electronic Component Connected to VHEAT Line Ln6)

When electric power supplied to the discharge terminal 41 becomes unstable, an amount of aerosol generated by the heater 21 varies, which may lead to deterioration of a fragrance taste. Therefore, as shown in FIG. 6, capacitors for stabilizing the fourth system voltage Vs4 output from the DC-DC converter 63 are connected to the VHEAT line Ln6.

More specifically, in the power supply unit 10, three capacitors, i.e., a capacitor Cd61, a capacitor Cd62, and a capacitor Cd63 are provided in parallel as the capacitors for stabilizing the fourth system voltage Vs4 output from the DC-DC converter 63. In this way, by stabilizing (smoothing) the voltage with the plurality of capacitors, heat generated by the stabilization of the voltage may be dispersed to the plurality of capacitors. Therefore, it is possible to prevent deterioration or failure of the capacitors by avoiding the capacitors from reaching a high temperature, as compared with a case in which a voltage is stabilized by one capacitor.

In particular, from the viewpoint of ensuring the amount of aerosol generated by the heater 21, a high voltage value is required for the fourth system voltage Vs4. If such a high voltage is stabilized by one capacitor, it is assumed that the capacitor reaches a very high temperature. As a result, not only the capacitor, which has reached a high temperature, is significantly deteriorated, but also other electronic components disposed around the capacitor may be adversely affected. Therefore, as described above, the fourth system voltage Vs4 is preferably stabilized by the plurality of capacitors.

Among the capacitor Cd61, the capacitor Cd62, and the capacitor Cd63, the capacitor Cd61 has a small static capacitance and accordingly has a small physical size. On the other hand, each of the capacitor Cd62 and the capacitor Cd63 has a large static capacitance and accordingly has a large physical size. As a specific example, the static capacitance of the capacitor Cd61 may be 0.1 [µF], and the static capacitances of the capacitor Cd62 and the capacitor Cd63 may be 50 [µF]. In this way, even when the fourth system voltage Vs4 contains various pulsating components (ripples), these components may be removed by using the plurality of capacitors having different static capacitances.

As shown in FIG. 6, in the present embodiment, a varistor VR4 is provided between the discharge terminal 41 and the switch Sw4 in the VHEAT line Ln6. More specifically, the varistor VR4 has one end connected to the VHEAT line Ln6, and the other end connected to the ground line. By providing such a varistor VR4, for example, even when noise of static electricity is generated at the discharge terminal 41 due to attachment and detachment of the first cartridge 20, the noise may be released to the ground line via the varistor VR4. Therefore, a system of the power supply unit 10 of the switch Sw4, the DC-DC converter 63, or the like may be protected from noise of the static electricity or the like generated at the discharge terminal 41.

As shown in FIG. 6, in the VHEAT line Ln6, a capacitor Cd7 for stabilizing the voltage supplied to the discharge terminal 41 via the switch Sw4 is also connected between the discharge terminal 41 and the switch Sw4. The capacitor Cd7 may also function as a protection component for protecting the system of the power supply unit 10 of the switch Sw4, the DC-DC converter 63, or the like from the noise of the static electricity or the like generated at the discharge terminal 41. Therefore, the capacitor Cd7 may also protect the system of the power supply unit 10 of the switch Sw4, the DC-DC converter 63, or the like from the noise of the static electricity or the like generated at the discharge terminal 41. Not only when the first cartridge 20 is attached or detached but also when the user touches the discharge terminal 41 or when a stress is applied to the discharge terminal 41, noise of static electricity or the like may be generated at the discharge terminal 41.

### (Suction Sensor)

The suction sensor 15 includes the VDD pin which is the power supply terminal on the high potential side, a GND pin which is a power supply terminal on a low potential side, and an OUT pin which is an output terminal.

As described above, the VDD pin of the suction sensor 15 is connected to the OUT pin of the LDO regulator 62 via the VSYS line Ln5. The GND pin of the suction sensor 15 is connected to the ground line. The OUT pin of the suction sensor 15 is connected to a PC5 pin of the MCU 50.

The suction sensor 15 operates when a power supply voltage is supplied based on a difference between a potential of the VDD pin and a potential of the GND pin. Specifically, the suction sensor 15 operates when the third system voltage Vs3 output from the LDO regulator 62 is supplied as a power supply voltage, and functions as a sensor device that detects a puff operation of the user. For example, the suction sensor 15 mainly includes a capacitor microphone, a pressure sensor, or the like, and outputs a signal indicating a value of a change in pressure (internal pressure) in the power supply unit 10 caused by suction of the user as a detection result from the OUT pin to the MCU 50. A sensor device other than the capacitor microphone or the pressure sensor may be adopted as the suction sensor 15.

### (MCU)

The MCU 50 includes the VDD pin which is the power supply terminal on the high potential side, a VSS pin which is a power supply terminal on a low potential side, and the plurality of pins which function as input terminals or output terminals (hereinafter, also referred to as input and output pins). The MCU 50 operates when a power supply voltage is supplied based on a difference between a potential of the VDD pin and a potential of the VSS pin.

Since the MCU 50 includes the PA11 pin and the PA12 pin as the input and output pins, the MCU 50 may communicate with the external device using these pins, and may acquire, for example, update data of firmware from the external device. In addition, since the MCU 50 includes the PB8 pin and the PB9 pin as the input and output pins, the MCU 50 may communicate with the charging IC 55 using these pins, and may acquire the battery information or the like from the charging IC 55.

Since the MCU 50 includes the PB14 pin and the PB2 pin as the input and output pins, the MCU 50 may control ON and OFF of the charging IC 55 by an output from the PB14 pin, and ON and OFF of the DC-DC converter 63 by an output from the PB2 pin.

Since the MCU 50 includes the PA0 pin, the PB3 pin, the PA8 pin, and the PB4 pin as the input and output pins, the MCU 50 may turn on and off the switch Sw1 by the output from the PA0 pin, may turn on and off the switch Sw2 by the output from the PB3 pin, may turn on and off the switch Sw3 by the output from the PA8 pin, and may turn on and off the switch Sw4 by the output from the PB4 pin.

Since the MCU 50 includes the PC5 pin, the PC4 pin, and the PC1 pin as the input and output pins, the MCU 50 may detect the puff operation of the user based on an input to the PC5 pin, the user operation on the operation switch OPS based on the input to the PC4 pin, and the temperature of the thermistor TH (that is, the temperature of the power supply BAT) based on the input to the PC1 pin when the switch Sw3 is turned on.

### (Internal Configuration of Power Supply Unit)

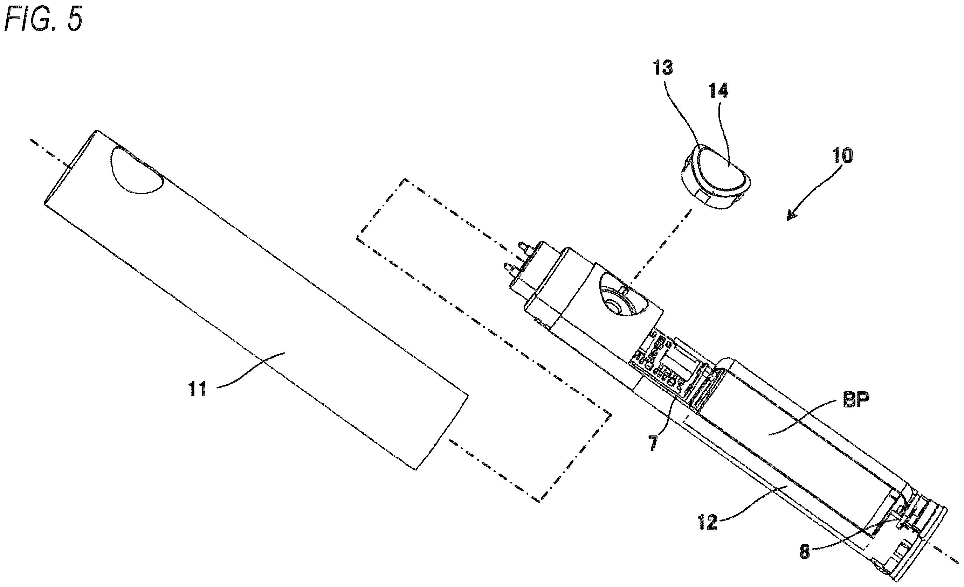

Next, the internal configuration of the power supply unit 10 will be described with reference to FIGs. 5 and 7 to 12.

A chassis 12 is provided in an internal space of the case 11, and the charging terminal 42 (see FIG. 3), the receptacle mounting substrate 8, the battery pack BP including the power supply BAT, and the MCU mounting substrate 7 are held by the chassis 12 in this order from the bottom portion 11c toward the top portion 11a.

In this way, by arranging the receptacle mounting substrate 8, the power supply BAT, and the MCU mounting substrate 7 in this order from the bottom portion 11c toward the top portion 11a (that is, in the X direction), the MCU mounting substrate 7 may be disposed at a position closer to the power supply BAT than a case in which the receptacle mounting substrate 8 is disposed between the power supply BAT and the MCU mounting substrate 7. By disposing the MCU mounting substrate 7 at the position close to the power supply BAT, it is possible to shorten a wiring distance between an electronic component (for example, the battery connector Cn3) connected to the power supply BAT and the power supply BAT in the MCU mounting substrate 7, and it is possible to downsize the power supply unit 10 by reducing excessive wiring. In addition, a cost for manufacturing the power supply unit 10 may also be decreased.

When the wiring distance between the electronic component connected to the power supply BAT and the power supply BAT is short, it is possible to reduce the number of electronic components affected by noise generated by current flowing through the wiring, as compared with a case in which the wiring distance is long. Therefore, even when a current value of the current flowing through the wiring (for example, a charging current for charging the power supply BAT or a discharging current from the power supply BAT) becomes large, it is possible to reduce the influence of the noise generated due to the current on the electronic components of the power supply unit 10 and to stabilize the operation of the power supply unit 10.

The chassis 12 holding the MCU mounting substrate 7, the battery pack BP, or the like is formed of an insulating material such as synthetic resin (for example, plastic). The chassis 12 includes a wall portion 12a that is provided between a portion holding the MCU mounting substrate 7 and a portion holding the battery pack BP in the X direction and that partitions the portions. The wall portion 12a may function as a spacer that insulates the MCU mounting substrate 7 from the power supply BAT of the battery pack BP.

In this way, by providing the wall portion 12a functioning as the insulating spacer between the MCU mounting substrate 7 and the battery pack BP, it is possible to avoid occurrence of short-circuiting due to physical contact between the MCU mounting substrate 7 and the power supply BAT. In the present embodiment, the spacer that insulates the MCU mounting substrate 7 from the power supply BAT is implemented by the wall portion 12a of the chassis 12, but the spacer is not limited thereto, and may be provided separately from the chassis 12, for example.

The case 11 is provided with the charging opening 43 for allowing access to the charging terminal 42, an operation opening for exposing the operation unit 14 to the outside, and a pair of discharge openings for exposing the discharge terminal 41 to the outside from the top portion 11a.

### (MCU Mounting Substrate)

The plurality of electronic components described in the circuit configuration (see FIG. 6 or the like) of the power supply unit 10 are mounted on the MCU mounting substrate 7. The MCU mounting substrate 7 is a multilayer substrate formed by stacking a plurality of layers, and has a substantially rectangular shape. The MCU mounting substrate 7 is disposed such that a longitudinal direction thereof is along an extending direction (that is, X direction) of the center line L of the case 11 and an element mounting surface on one side faces the operation unit 14.

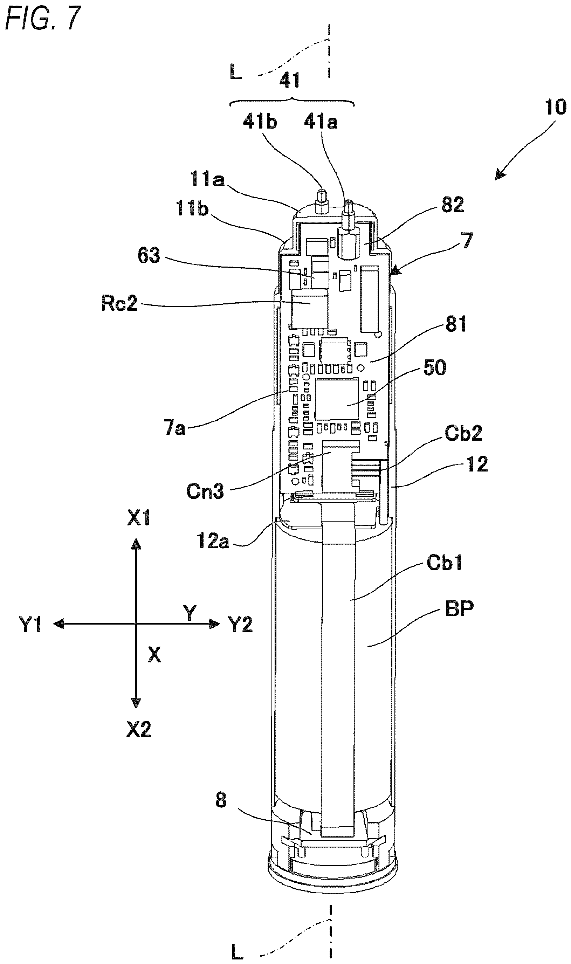

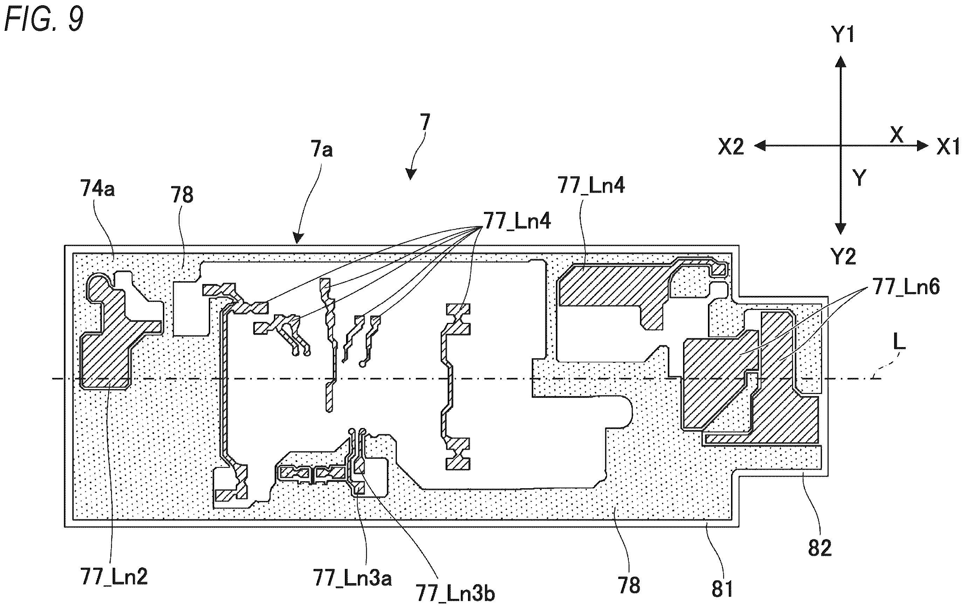

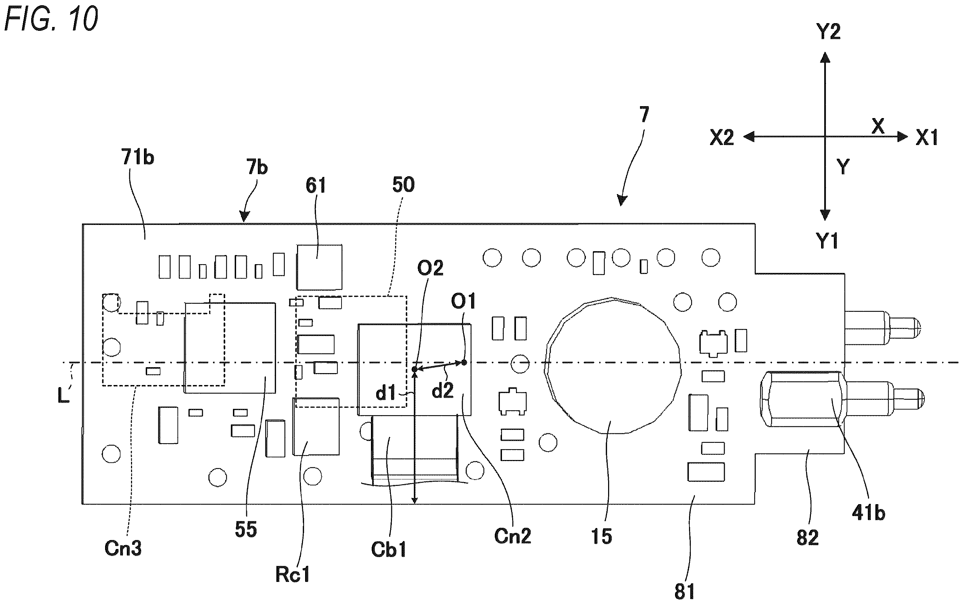

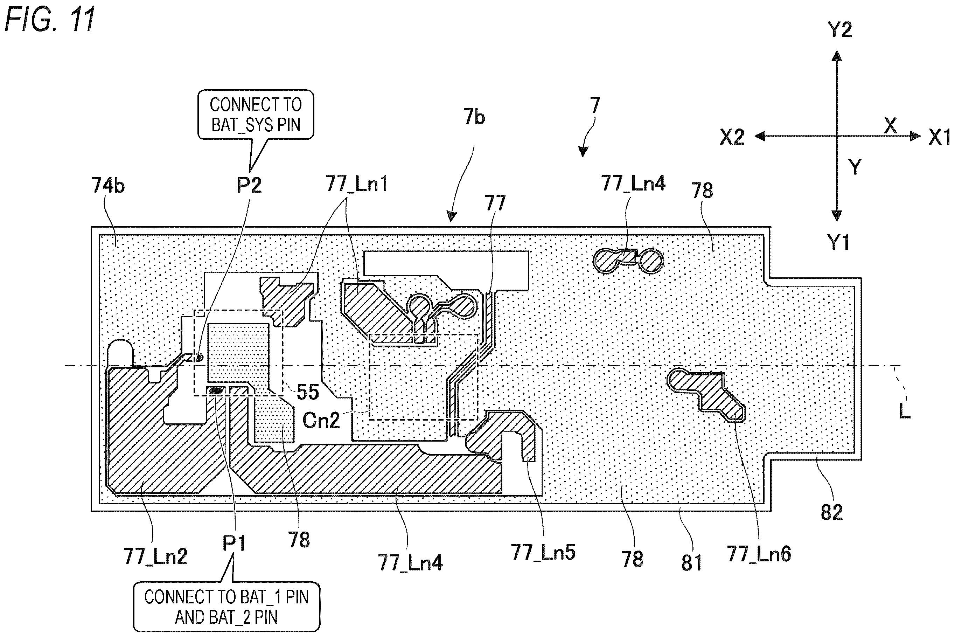

In the following description, the X direction may be referred to as a longitudinal direction X, and in the X direction, a top portion 11a side is referred to as an X1 direction, and the bottom portion 11c side is referred to as an X2 direction. In addition, on the MCU mounting substrate 7, a direction orthogonal to the longitudinal direction X is referred to as a lateral direction Y, and in the lateral direction Y, one side (left side in FIG. 7, upper side in FIGs. 8 and 9, and lower side in FIGs. 10 and 11) is referred to as a Y1 direction, and the other side (right side in FIG. 7, lower side in FIGs. 8 and 9, and upper side in FIGs. 10 and 11) is referred to as a Y2 direction. The longitudinal direction X may be referred to as a length direction of the MCU mounting substrate 7, and the lateral direction Y may be referred to as a width direction of the MCU mounting substrate 7. A center line of the MCU mounting substrate 7 coincides with the center line L extending in the X direction of the power supply unit 10 (case 11). The center line of the MCU mounting substrate 7 is a line continuously connecting, in the longitudinal direction X, center points in the width direction (lateral direction) and a thickness direction of the MCU mounting substrate 7 when the MCU mounting substrate 7 is cut along a plane orthogonal to the longitudinal direction X.

As shown in FIG. 7, the MCU mounting substrate 7 includes a rectangular portion 81 occupying most of the MCU mounting substrate 7 and a protruding portion 82 protruding from the rectangular portion 81 in the X1 direction. Both end portions in the lateral direction Y of the protruding portion 82 are cut out, an end portion in the X1 direction of the protruding portion 82 faces the top portion 11a of the case 11, and an end portion in the X1 direction of the rectangular portion 81 in which the protruding portion 82 is not provided faces the low floor portion 11b of the case 11.

When a surface of the MCU mounting substrate 7 on an operation unit 14 side is referred to as a main surface 7a and a surface of the MCU mounting substrate 7 on a side opposite to the operation unit 14 side (that is, back surface) is referred to as a sub surface 7b, the MCU mounting substrate 7 is a double-sided mounting substrate on which electronic components are mounted on both the main surface 7a and the sub surface 7b.

As shown in FIG. 8, the battery connector Cn3, the MCU 50, the operation switch OPS, the LED L1, the LED L2, the DC-DC converter 63, the reactor Rc2, the capacitor Cd61, the capacitor Cd62, the capacitor Cd63, the switch Sw4, the capacitor Cd7, the varistor VR4, the positive electrode-side discharge terminal 41a, and the like are mounted on the main surface-side surface layer 71a of the main surface 7a (hereinafter, simply referred to as the main surface 7a).

More specifically, the button-type operation switch OPS is mounted substantially on a center of the main surface 7a so as to face the operation unit 14. Accordingly, the user may press down the operation switch OPS via the operation unit 14 of the case 11. In addition, the LED L1 and the LED L2 are mounted in the vicinity of the operation switch OPS so as to sandwich the operation switch OPS in the lateral direction Y Accordingly, the user may visually recognize light emitted from the LED L1 and the LED L2 through the LED window 13 provided around the operation unit 14.

The battery connector Cn3 is mounted on an end portion in the X2 direction of the main surface 7a. The battery connection cable Cb2 extending from the battery pack BP including the power supply BAT is connected to the battery connector Cn3 from a Y2 direction side (see also FIG. 7).

Here, the end portion in the X2 direction on which the battery connector Cn3 is mounted is at a position close to the power supply BAT. In this way, by disposing the battery connector Cn3 at the position close to the power supply BAT, the battery connection cable Cb2 may be shortened, and the power supply unit 10 may be downsized. In addition, a cost for manufacturing the power supply unit 10 may also be decreased. In addition, by shortening the battery connection cable Cb2, even when a current value of current flowing through the battery connection cable Cb2, such as the charging current for charging the power supply BAT or the discharging current from the power supply BAT, becomes large, it is possible to reduce the influence of the noise generated due to the current on the electronic components of the power supply unit 10 and to stabilize the operation of the power supply unit 10.

As described above, the wall portion 12a, which is the spacer that insulates the MCU mounting substrate 7 from the battery pack BP (that is, the power supply BAT), is provided between the MCU mounting substrate 7 and the battery pack BP in the longitudinal direction X. Therefore, in the present embodiment, the battery connector Cn3 is mounted on the MCU mounting substrate 7 in a state of being oriented in the Y2 direction, and the battery connection cable Cb2 is connected to the battery connector Cn3 from the Y2 direction side. Accordingly, it is possible to avoid the battery connection cable Cb2 and the wall portion 12a from physically interfering with each other without making the battery connection cable Cb2 and/or the wall portion 12a have a complicated shape.

In the present embodiment, the battery connector Cn3 is mounted on the MCU mounting substrate 7 in the state of being oriented in the Y2 direction, and the battery connection cable Cb2 is connected to the battery connector Cn3 from the Y2 direction side, but the present invention is not limited thereto. The battery connector Cn3 may be mounted on the MCU mounting substrate 7 in a state of being oriented in the Y1 direction, and the battery connection cable Cb2 may be connected to the battery connector Cn3 from a Y1 direction side.

In FIG. 8, a broken line indicated by reference sign 55 indicates a mounting position of the charging IC 55 mounted on the sub surface 7b which is the back surface of the main surface 7a. That is, the battery connector Cn3 and the charging IC 55 are mounted on different surfaces of the MCU mounting substrate 7 such that at least a part of the battery connector Cn3 overlaps the charging IC 55 in a direction orthogonal to the MCU mounting substrate 7. The direction orthogonal to the MCU mounting substrate 7 indicates a direction orthogonal to the longitudinal direction X and the lateral direction Y

Each of the battery connector Cn3 and the charging IC 55 has a large physical size and easily occupies a large area on the MCU mounting substrate 7. Therefore, by mounting the battery connector Cn3 and the charging IC 55 on different surfaces of the MCU mounting substrate 7, both the main surface 7a and the sub surface 7b may be effectively used to mount the battery connector Cn3 and the charging IC 55. Accordingly, the battery connector Cn3 and the charging IC 55 may be mounted on the MCU mounting substrate 7 while avoiding an increase in size of the MCU mounting substrate 7.

Since at least a part of the battery connector Cn3 overlaps the charging IC 55 in a direction orthogonal to the main surface 7a of the MCU mounting substrate 7, a wiring distance between the battery connector Cn3 and the charging IC 55 may be shortened. Accordingly, the MCU mounting substrate 7 may be downsized by reducing the excessive wiring (for example, the conductive pattern formed on the MCU mounting substrate 7). In addition, a cost for manufacturing the MCU mounting substrate 7 may also be reduced. In addition, if the wiring distance between the battery connector Cn3 and the charging IC 55 is short, even when a current value of current flowing through the wiring (for example, the VBAT line Ln2) becomes large, it is possible to reduce the influence of noise generated due to the current on other electronic components on the MCU mounting substrate 7 and to stabilize the operation of the power supply unit 10. The current flowing through the wiring between the battery connector Cn3 and the charging IC 55 is, for example, the charging current for charging the power supply BAT (hereinafter, also simply referred to as a charging current) or the discharging current (hereinafter, also simply referred to as a discharging current) from the power supply BAT.

The positive electrode-side discharge terminal 41a is mounted on the protruding portion 82 which is the end portion of the main surface 7a in the X1 direction. The heater 21 provided in the first cartridge 20 is connected to the positive electrode-side discharge terminal 41a. The end portion in the X1 direction on which the positive electrode-side discharge terminal 41a is mounted is at a position close to the first cartridge 20. In this way, by disposing the positive electrode-side discharge terminal 41a at the position close to the first cartridge 20, the positive electrode-side discharge terminal 41a and the heater 21 may be easily and efficiently connected to each other.

The positive electrode-side discharge terminal 41a is disposed on a Y2 direction side of the protruding portion 82 with the center line L interposed therebetween. On the other hand, the switch Sw4 is disposed on a Y1 direction side of the protruding portion 82 with the center line L interposed therebetween.

The DC-DC converter 63, the reactor Rc2, the capacitor Cd61, the capacitor Cd62, the capacitor Cd63, the capacitor Cd7, and the like are mounted on the main surface 7a between the operation switch OPS and the switch Sw4 in the X direction.

As shown in FIG. 8, the DC-DC converter 63, the capacitor Cd61, the capacitor Cd62, and the capacitor Cd63 are arranged in a substantially L-shape when viewed from the direction orthogonal to the MCU mounting substrate 7 (hereinafter, also referred to as a plan view of the MCU mounting substrate 7).

More specifically, the capacitor Cd61 is arranged in a line with the DC-DC converter 63 and the capacitor Cd62 in the lateral direction Y (that is, the width direction of the MCU mounting substrate 7), but is not arranged in a line with the capacitor Cd63. Here, the expression "arranged in a line in the lateral direction Y" means that, when viewed from the lateral direction Y, at least a part thereof overlaps each other.

The capacitor Cd63 is arranged in a line with the DC-DC converter 63 in the longitudinal direction X (that is, the length direction of the MCU mounting substrate 7), but is not arranged in a line with the capacitor Cd61 and the capacitor Cd62. Here, the expression "arranged in a line in the longitudinal direction X" means that, when viewed from the longitudinal direction X, at least a part thereof overlaps each other.

That is, as shown in FIG. 8, the capacitor Cd61 and the capacitor Cd63 are not arranged in a line in the longitudinal direction X which is the length direction of the MCU mounting substrate 7 and in the lateral direction Y which is the width direction of the MCU mounting substrate 7. Similarly, the capacitor Cd62 and the capacitor Cd63 are not arranged in a line in the longitudinal direction X and in the lateral direction Y

If the capacitor Cd61 or the capacitor Cd62 and the capacitor Cd63 are arranged in a line in the longitudinal direction X or in the lateral direction Y and mounted on the MCU mounting substrate 7, the size in the longitudinal direction X (that is, the size in the length direction, hereinafter, also referred to as a length dimension) or the size in the lateral direction Y of the MCU mounting substrate 7 (that is, the size in the width direction, hereinafter, also referred to as a width dimension) may be increased in order to ensure a space in which the capacitors are arranged.

Therefore, in the present embodiment, by mounting the capacitor Cd61 or the capacitor Cd62 and the capacitor Cd63 on the MCU mounting substrate 7 so as not to be arranged in a line in the longitudinal direction X and in the lateral direction Y, increase in the length dimension and the width dimension of the MCU mounting substrate 7 is avoided, as compared with a case in which these capacitors are arranged in a line. Accordingly, the MCU mounting substrate 7 may be downsized, and the cost for manufacturing the MCU mounting substrate 7 may be decreased. In addition, the power supply unit 10 itself may also be downsized by decreasing the size of the MCU mounting substrate 7. Accordingly, the portability of the aerosol inhalation device 1 is improved, and the convenience for the user may be improved.

In the present embodiment, the number of capacitors mounted on the MCU mounting substrate 7 so as to be arranged in a line with the DC-DC converter 63 in the longitudinal direction X is one (only the capacitor Cd63), and is smaller than the number of capacitors (two of the capacitor Cd61 and the capacitor Cd62) mounted on the MCU mounting substrate 7 so as to be arranged in a line with the DC-DC converter 63 in the lateral direction Y In this way, by setting the number of capacitors mounted on the MCU mounting substrate 7 so as to be arranged in a line with the DC-DC converter 63 in the longitudinal direction X to be smaller than the number of capacitors mounted on the MCU mounting substrate 7 so as to be arranged in a line with the DC-DC converter 63 in the lateral direction Y, it is possible to avoid an increase in the length dimension of the MCU mounting substrate 7 and to decrease the size of the MCU mounting substrate 7.

Therefore, as described above, the static capacitance of the capacitor Cd63 is larger than the static capacitance of the capacitor Cd61. In this way, by arranging the capacitor Cd63, which tends to have a large static capacitance and a large physical size, with the DC-DC converter 63 in the longitudinal direction X, it is possible to avoid an increase in the width dimension of the MCU mounting substrate 7, as compared with a case in which the capacitor Cd63 and the DC-DC converter 63 are arranged in the lateral direction Y Therefore, the MCU mounting substrate 7 may be downsized.

As described above, the static capacitance of the capacitor Cd62 is also larger than the static capacitance of the capacitor Cd61. In this way, by arranging the capacitor Cd62, which tends to have a large static capacitance and a large physical size, with the DC-DC converter 63 in the lateral direction X, it is possible to avoid the arrangement of the capacitor Cd62 and the capacitor Cd63 in the lateral direction Y Accordingly, it is possible to avoid an increase in the width dimension of the MCU mounting substrate 7, as compared with the case in which the capacitor Cd62 and the capacitor Cd63 are arranged in the lateral direction Y Therefore, the MCU mounting substrate 7 may be downsized.

The DC-DC converter 63, the capacitor Cd61, and the capacitor Cd62 are arranged in a line in this order in the lateral direction Y That is, a large number of vias or the like tend to be provided in the MCU mounting substrate 7 around the DC-DC converter 63. Therefore, a capacitor having a large capacitance and a large size such as the capacitor Cd62 is less likely to be mounted on the MCU mounting substrate 7 in the vicinity of the DC-DC converter 63. On the other hand, a capacitor having a small size such as the capacitor Cd61 is likely to be mounted on the MCU mounting substrate 7 in the vicinity of the DC-DC converter 63. Therefore, by arranging the DC-DC converter 63, the capacitor Cd61, and the capacitor Cd62 in this order in the lateral direction Y, the DC-DC converter 63, the capacitor Cd61, and the capacitor Cd62 may be mounted on the MCU mounting substrate 7 at high density, and a substrate area of the MCU mounting substrate 7 may be effectively used to downsize of the MCU mounting substrate 7.

The capacitor Cd63 has a rectangular shape with long sides and short sides in the plan view of the MCU mounting substrate 7. The capacitor Cd63 is mounted on the MCU mounting substrate 7 such that the short sides are parallel to the longitudinal direction X. In other words, the capacitor Cd63 is mounted on the MCU mounting substrate 7 such that a lateral direction of the capacitor Cd63 coincides with the longitudinal direction X of the MCU mounting substrate 7. Accordingly, even when the capacitor Cd63 is arranged with the DC-DC converter 63 in the longitudinal direction X, it is possible to prevent an increase in the length dimension of the MCU mounting substrate 7. Therefore, the MCU mounting substrate 7 may be downsized.

The capacitor Cd62 has a rectangular shape with long sides and short sides in the plan view of the MCU mounting substrate 7. The capacitor Cd62 is mounted on the MCU mounting substrate 7 such that the long sides are parallel to the longitudinal direction X. In other words, the capacitor Cd62 is mounted on the MCU mounting substrate 7 such that a lateral direction of the capacitor Cd62 coincides with the lateral direction Y of the MCU mounting substrate 7. Accordingly, even when the capacitor Cd62 is arranged with the DC-DC converter 63 in the lateral direction Y, it is possible to prevent an increase in the width dimension of the MCU mounting substrate 7. Therefore, the MCU mounting substrate 7 may be downsized.

As shown in FIG. 10, the charging IC 55, the reactor Rc1, the protection IC 61, the MCU mounting substrate-side connector Cn2, the suction sensor 15, the negative electrode-side discharge terminal 41b, and the like are mounted on a sub surface-side surface layer 71b of the sub surface 7b (hereinafter, simply referred to as the sub surface 7b).

More specifically, the MCU mounting substrate-side connector Cn2 is mounted substantially on a center of the sub surface 7b. When a mounting position of the MCU mounting substrate-side connector Cn2 is described in detail, reference sign O1 in FIG. 10 indicates a center of the MCU mounting substrate 7 when viewed from the direction orthogonal to the MCU mounting substrate 7. The center O1 of the MCU mounting substrate 7 is a point on the center line of the MCU mounting substrate 7 that coincides with the center line L of the case 11 and at the center of the MCU mounting substrate 7 in the longitudinal direction X.

Reference sign O2 in FIG. 10 indicates a center of the MCU mounting substrate-side connector Cn2 when viewed from the direction orthogonal to the MCU mounting substrate 7. The MCU mounting substrate-side connector Cn2 has a substantially rectangular shape in which two sides are parallel to the longitudinal direction X and the other two sides are parallel to the lateral direction Y in the plan view of the MCU mounting substrate 7. Therefore, the center O2 of the MCU mounting substrate-side connector Cn2 is a point at a center of the MCU mounting substrate-side connector Cn2 in the longitudinal direction X and at a center of the MCU mounting substrate-side connector Cn2 in the lateral direction Y

In the present embodiment, the MCU mounting substrate-side connector Cn2 is mounted on the sub surface 7b of the MCU mounting substrate 7 such that a shortest distance d1 between an edge of the MCU mounting substrate 7 closest to the MCU mounting substrate-side connector Cn2 and the center O2 of the MCU mounting substrate-side connector Cn2 is longer than a shortest distance d2 between the center O1 of the MCU mounting substrate 7 and the center O2 of the MCU mounting substrate-side connector Cn2.

In this way, the MCU mounting substrate-side connector Cn2 may be mounted substantially on the center of the MCU mounting substrate 7 (here, the sub surface 7b) by mounting the MCU mounting substrate-side connector Cn2 on the MCU mounting substrate 7 such that the shortest distance d1 between the edge of the MCU mounting substrate 7 closest to the MCU mounting substrate-side connector Cn2 and the MCU mounting substrate-side connector Cn2 is longer than the shortest distance d2 between the center of the MCU mounting substrate 7 and the MCU mounting substrate-side connector Cn2.

By mounting the MCU mounting substrate-side connector Cn2 substantially on the center of the MCU mounting substrate 7, it is possible to shorten a wiring distance between the MCU mounting substrate-side connector Cn2 and the other electronic components mounted on the MCU mounting substrate 7, as compared with a case in which the MCU mounting substrate-side connector Cn2 is mounted on an end portion of the MCU mounting substrate 7. This is because many electronic components may be easily mounted around and near the MCU mounting substrate-side connector Cn2. Accordingly, it is possible to shorten the conductive pattern formed on the MCU mounting substrate 7 as wiring for connecting the MCU mounting substrate-side connector Cn2 and the other electronic components mounted on the MCU mounting substrate 7. Therefore, the MCU mounting substrate 7 may be downsized by reducing the excessive conductive patterns. In addition, a cost for manufacturing the MCU mounting substrate 7 may also be reduced.

The substrate connection cable Cb1 extending from the receptacle mounting substrate 8 on which the charging terminal 42 or the like is mounted is connected to the MCU mounting substrate-side connector Cn2. More specifically, in the present embodiment, the MCU mounting substrate-side connector Cn2 is mounted on the MCU mounting substrate 7 in a state of being oriented in the Y1 direction, and the substrate connection cable Cb1 is connected to the MCU mounting substrate-side connector Cn2 from the Y1 direction side.

In this way, by connecting the substrate connection cable Cb1 to the MCU mounting substrate-side connector Cn2 from the lateral direction Y of the MCU mounting substrate 7, even when the MCU mounting substrate-side connector Cn2 is mounted substantially on the center of the MCU mounting substrate 7, the other electronic components mounted on the MCU mounting substrate 7 and the substrate connection cable Cb1 are less likely to physically interfere with each other. Therefore, it is possible to improve the durability of the other electronic components mounted on the MCU mounting substrate 7, and to improve the degree of freedom of a layout of each electronic component on the MCU mounting substrate 7.

On the other hand, when the MCU mounting substrate-side connector Cn2 is mounted substantially on the center of the MCU mounting substrate 7 and the substrate connection cable Cb1 is connected to the MCU mounting substrate-side connector Cn2 in the longitudinal direction X of the MCU mounting substrate 7, the electronic components arranged in a line with the MCU mounting substrate-side connector Cn2 in the longitudinal direction X may be restricted in that no electronic component having a large height may be used, from the viewpoint of avoiding the physical interference with the substrate connection cable Cb1.

In the present embodiment, the MCU mounting substrate-side connector Cn2 is mounted on the MCU mounting substrate 7 in the state of being oriented in the Y1 direction, and the substrate connection cable Cb1 is connected to the MCU mounting substrate-side connector Cn2 from the Y1 direction side, but the present invention is not limited thereto. The MCU mounting substrate-side connector Cn2 may be mounted on the MCU mounting substrate 7 in a state of being oriented in the Y2 direction, and the substrate connection cable Cb1 may be connected to the MCU mounting substrate-side connector Cn2 from the Y2 direction side.

The charging IC 55 is mounted on the sub surface 7b on the X2 direction side of the MCU mounting substrate-side connector Cn2. Accordingly, the charging IC 55 may be disposed at a position close to the battery connector Cn3 mounted on the end portion in the X2 direction of the main surface 7a. As described above, at least a part of the battery connector Cn3 may overlap the charging IC 55 in the direction orthogonal to the main surface 7a of the MCU mounting substrate 7.

On the sub surface 7b, between the charging IC 55 and the MCU mounting substrate-side connector Cn2 in the longitudinal direction X, the reactor Rc1 is mounted near the Y1 direction and the protection IC 61 is mounted near the Y2 direction in the lateral direction Y

The suction sensor 15 is mounted on the sub surface 7b on an X1 direction side of the MCU mounting substrate-side connector Cn2. Accordingly, in the power supply unit 10, the receptacle mounting substrate 8 (see FIG. 7) disposed on an X2 direction side with respect to the MCU mounting substrate 7, the MCU mounting substrate-side connector Cn2, and the suction sensor 15 are arranged in this order from the X2 direction toward the X1 direction. In other words, the suction sensor 15 is not disposed between the receptacle mounting substrate 8 disposed on the X2 direction side with respect to the MCU mounting substrate 7 and the MCU mounting substrate-side connector Cn2 in the longitudinal direction X.

The suction sensor 15 is an electronic component having a larger height from the sub surface 7b (sub surface-side surface layer 71b) than the MCU mounting substrate-side connector Cn2. This is because the suction sensor 15 is likely to be increased in size due to a structure for detecting suction by vibration or the like of a diaphragm provided inside. When the suction sensor 15 is disposed on the MCU mounting substrate 7 on the X2 direction side of the MCU mounting substrate-side connector Cn2 (that is, between the receptacle mounting substrate 8 and the MCU mounting substrate-side connector Cn2), the substrate connection cable Cb1 connected to the MCU mounting substrate-side connector Cn2 and the suction sensor 15 are likely to physically interfere with each other. In order to avoid the interference, the substrate connection cable Cb1 must have a complicated shape.

Therefore, in the present embodiment, the suction sensor 15 is disposed on the MCU mounting substrate 7 on the X1 direction side of the MCU mounting substrate-side connector Cn2 (that is, side opposite to the receptacle mounting substrate 8). Accordingly, it is possible to easily avoid the substrate connection cable Cb1 and the suction sensor 15 from physically interfering with each other without making the substrate connection cable Cb1 have a complicated shape. Therefore, it is possible to prevent an increase in cost for manufacturing the power supply unit 10 due to the complicated shape of the substrate connection cable Cb1.

In the present embodiment, similar to the suction sensor 15, the reactor Rc2 and the operation switch OPS are electronic components each having a height larger than that of the MCU mounting substrate-side connector Cn2 (that is, electronic components each having a large height from a mounting surface of the MCU mounting substrate 7). Therefore, in the present embodiment, as described above, by mounting the reactor Rc2 and the operation switch OPS on the main surface 7a, the other electronic components and the substrate connection cable Cb1 are less likely to physically interfere with each other without making the substrate connection cable Cb1 have a complicated shape.

In the present embodiment, as described above, the battery connector Cn3 and the MCU mounting substrate-side connector Cn2 are mounted on different surfaces of the MCU mounting substrate 7 such that the battery connector Cn3 is mounted on the main surface 7a and the MCU mounting substrate-side connector Cn2 is mounted on the sub surface 7b. Each of the battery connector Cn3 and the MCU mounting substrate-side connector Cn2 has a large physical size and easily occupies a large area on the MCU mounting substrate 7. Therefore, by mounting the battery connector Cn3 and the MCU mounting substrate-side connector Cn2 on different surfaces of the MCU mounting substrate 7, both the main surface 7a and the sub surface 7b may be effectively used to mount the battery connector Cn3 and the MCU mounting substrate-side connector Cn2. Accordingly, the battery connector Cn3 and the MCU mounting substrate-side connector Cn2 may be mounted on the MCU mounting substrate 7 while avoiding an increase in size of the MCU mounting substrate 7.

In FIG. 10, a broken line indicated by reference sign 50 indicates a mounting position of the MCU 50 mounted on the main surface 7a which is a back surface of the sub surface 7b. That is, the MCU mounting substrate-side connector Cn2 and the MCU 50 are mounted on different surfaces of the MCU mounting substrate 7 such that at least a part of the MCU mounting substrate-side connector Cn2 overlaps the MCU 50 in the direction orthogonal to the main surface 7a of the MCU mounting substrate 7.

In general, in the MCU mounting substrate 7, a portion on which a connector such as the MCU mounting substrate-side connector Cn2 is mounted tends to have fewer conductive patterns, vias, or the like to be provided than in other portions. Therefore, in the MCU mounting substrate 7, a back side of the portion on which the connector such as the MCU mounting substrate-side connector Cn2 is mounted is easily provided with conductive patterns, vias, or the like necessary for the other electronic components. Therefore, by mounting an IC that uses many conductive patterns or vias of the MCU 50 or the like at a position overlapping the MCU mounting substrate-side connector Cn2 in the direction orthogonal to the MCU mounting substrate 7, the substrate area of the MCU mounting substrate 7 may be effectively used to downsize the MCU mounting substrate 7.

In the present embodiment, an electronic component overlapping the MCU mounting substrate-side connector Cn2 in the direction orthogonal to the MCU mounting substrate 7 is the MCU 50, but the present invention is not limited thereto, and any electronic component may be used. As described above, from the viewpoint of effectively using the substrate area of the MCU mounting substrate 7, it is desirable to mount the IC that uses many conductive patterns, vias, or the like.

In FIG. 10, a broken line indicated by reference sign Cn3 indicates a mounting position of the battery connector Cn3 mounted on the main surface 7a which is the back surface of the sub surface 7b. That is, the battery connector Cn3 is mounted on the X2 direction side of the MCU mounting substrate-side connector Cn2. Therefore, in the power supply unit 10, the receptacle mounting substrate 8, the battery pack BP including the power supply BAT, the battery connector Cn3, and the MCU mounting substrate-side connector Cn2 are arranged in this order from the X2 direction side toward the X1 direction side (that is, in the longitudinal direction X). Accordingly, the battery connector Cn3 is disposed at the position close to the power supply BAT, and the battery connection cable Cb2 may be shortened, and thus the power supply unit 10 may be downsized. In addition, it is possible to decrease the cost for manufacturing the power supply unit 10, and furthermore, it is possible to reduce the influence of noise generated due to current flowing through the battery connection cable Cb2 on the electronic components of the power supply unit 10 and to stabilize the operation of the power supply unit 10.

The negative electrode-side discharge terminal 41b is mounted on the protruding portion 82 which is an end portion of the sub surface 7b in the X1 direction. The heater 21 provided in the first cartridge 20 is connected to the negative electrode-side discharge terminal 41b. The end portion in the X1 direction on which the negative electrode-side discharge terminal 41b is mounted is at a position close to the first cartridge 20. In this way, by disposing the negative electrode-side discharge terminal 41b at the position close to the first cartridge 20, the negative electrode-side discharge terminal 41b and the heater 21 may be easily and efficiently connected to each other.

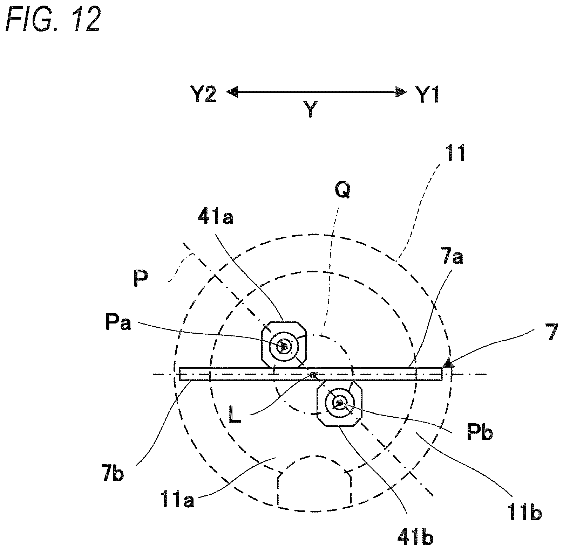

The negative electrode-side discharge terminal 41b is disposed on the Y1 direction side of the protruding portion 82 with the center line L interposed therebetween. As described above, the positive electrode-side discharge terminal 41a is mounted on the main surface 7a, and the negative electrode-side discharge terminal 41b is mounted on the sub surface 7b of the MCU mounting substrate 7. Here, each of the positive electrode-side discharge terminal 41a and the negative electrode-side discharge terminal 41b has a probe. As shown in FIG. 12, when viewed from the extending direction (X direction) of the center line L of the case 11, a virtual line P connecting a center Pa of the probe of the positive electrode-side discharge terminal 41a and a center Pb of the probe of the negative electrode-side discharge terminal 41b passes through the center line L, and the center Pa of the probe of the positive electrode-side discharge terminal 41a and the center Pb of the probe of the negative electrode-side discharge terminal 41b are arranged on a circle Q passing through the center line L.

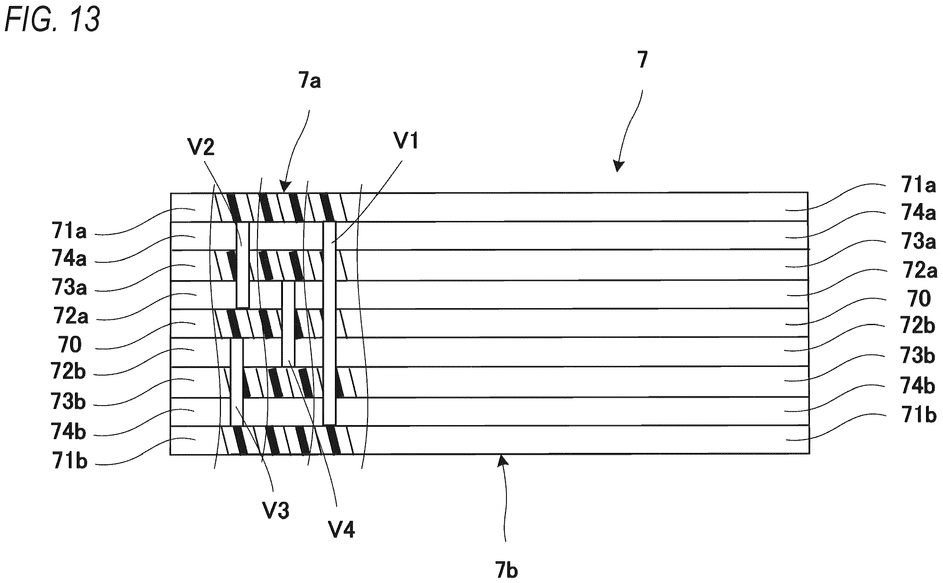

As shown in FIG. 13, the MCU mounting substrate 7 is provided with a first wiring layer 72a, a main surface-side insulating layer 73a, and a second wiring layer 74a in this order from a base layer 70 toward the main surface-side surface layer 71a, and is further provided with a third wiring layer 72b, a sub surface-side insulating layer 73b, and a fourth wiring layer 74b in this order from the base layer 70 toward the sub surface-side surface layer 71b. The MCU mounting substrate 7 is not limited thereto, and various configurations may be adopted. For example, the plurality of second wiring layers 74a and/or fourth wiring layers 74b may be provided, and only one of the first wiring layer 72a and the third wiring layer may be provided.

### (Conductive Pattern of MCU Mounting Substrate)

The second wiring layer 74a and the fourth wiring layer 74b are provided with conductive patterns formed of copper foil or the like. Similar to the second wiring layer 74a and the fourth wiring layer 74b, the first wiring layer 72a and the third wiring layer 72b may also be provided with conductive patterns formed of copper foil or the like. In the following description, conductive patterns constituting a power supply line and a signal line of the MCU mounting substrate 7 are referred to as a wiring pattern 77, and a conductive pattern constituting the ground line is referred to as the ground pattern 78. In the present specification or the like, among the wiring patterns 77, one constituting the VBUS line Ln1 may be referred to as a wiring pattern 77_Ln1, one constituting the VBAT line Ln2 may be referred to as a wiring pattern 77_Ln2, one constituting the D+ line Ln3a may be referred to as a wiring pattern 77_Ln3a, one constituting the D- line Ln3b may be referred to as a wiring pattern 77 _Ln3b, one constituting the power-path line Ln4 may be referred to as a wiring pattern 77_Ln4, one constituting the VSYS line Ln5 may be referred to as a wiring pattern 77_Ln5, and one constituting the VHEAT line Ln6 may be referred to as a wiring pattern 77_Ln6.

As shown in FIGs. 9 and 11, the ground pattern 78 is provided so as to surround the wiring patterns 77. FIG. 9 is a diagram showing the second wiring layer 74a of the MCU mounting substrate 7, and FIG. 11 is a diagram showing the fourth wiring layer 74b of the MCU mounting substrate 7. In FIGs. 9 and 11, a portion indicated by diagonal hatching is the wiring pattern 77, and a portion indicated by dot hatching is the ground pattern 78. It should be noted that FIGs. 9 and 11 show only some of the wiring patterns 77 provided on the MCU mounting substrate 7.

In FIG. 11, the broken line indicated by the reference sign 55 illustrates the charging IC 55 mounted on the sub surface 7b (sub surface-side surface layer 71b). The charging IC 55 is mounted on the MCU mounting substrate 7 in such a manner that the BAT_1 pin and the BAT_2 pin are connected to a portion indicated by reference sign P1 in FIG. 11 and the BAT_SNS pin is connected to a portion indicated by reference sign P2 in FIG. 11 in the wiring pattern 77_Ln2 constituting the VBAT line Ln2. Here, the portion indicated by the reference signP2 is a portion closer to the end portion on the X2 direction side of the MCU mounting substrate 7 than the portion indicated by the reference sign P1.

That is, the BAT SNS pin which is the detection terminal for detecting the output voltage or the like of the power supply BAT is disposed closer to the end portion on the X2 direction side on the MCU mounting substrate 7 than the BAT_1 pin and the BAT_2 pin which are the input and output terminals used for transmitting and receiving the electric power between the charging IC 55 and the power supply BAT. Accordingly, the BAT_SNS pin may be disposed at a position close to the power supply BAT, and a wiring distance between the power supply BAT and the BAT_SNS pin may be shortened. Therefore, the influence of a conductor resistance or the like included in the input to the BAT_SNS pin may be reduced, and the charging IC 55 may accurately detect the output voltage of the power supply BAT based on the input to the BAT_SNS pin. The charging IC 55 may accurately detect the output voltage of the power supply BAT, and an accuracy or a speed of the charging of the power supply BAT by the charging IC 55 may be improved as a result.

In FIG. 11, a broken line indicated by referencesign Cn2 indicates the MCU mounting substrate-side connector Cn2 mounted on the sub surface 7b (sub surface-side surface layer 71b). As shown in FIG. 11, the wiring pattern 77 is formed on the sub surface 7b of the MCU mounting substrate 7 at a portion overlapping the MCU mounting substrate-side connector Cn2. That is, as described above, the portion on which the connector such as the MCU mounting substrate-side connector Cn2 is mounted tends to have fewer conductive patterns or vias to be provided than in the other portions. Therefore, by forming the wiring pattern 77 for connecting the other electronic components mounted on the MCU mounting substrate 7 at the portion overlapping the MCU mounting substrate-side connector Cn2 on the MCU mounting substrate 7, the substrate area of the MCU mounting substrate 7 may be effectively used to decrease the size of the MCU mounting substrate 7. The type or the like of the electronic components to which the wiring pattern 77 formed at the portion overlapping the MCU mounting substrate-side connector Cn2 is connected is not particularly limited.

When an example of vias provided in the MCU mounting substrate 7 will be additionally described with reference to FIG. 13, in FIG. 13, a via V1 is implemented by a conductor penetrating from the second wiring layer 74a to the fourth wiring layer 74b, and conductive patterns electrically connected to the via V1 among the conductive patterns formed in the first wiring layer 72a, the second wiring layer 74a, the third wiring layer 72b, and the fourth wiring layer 74b have the same potential. For example, the predetermined wiring pattern 77 formed in the second wiring layer 74a and the predetermined wiring pattern 77 formed in the fourth wiring layer 74b are electrically connected to each other through the via V1. Similarly, in FIG. 13, a via V2 is implemented by a conductor penetrating from the second wiring layer 74a to the first wiring layer 72a, and conductive patterns electrically connected to the via V2 among the conductive patterns formed in the first wiring layer 72a and the second wiring layer 74a have the same potential. In addition, a via V3 is implemented by a conductor penetrating from the third wiring layer 72b to the fourth wiring layer 74b, and conductive patterns electrically connected to the via V3 among the conductive patterns formed in the third wiring layer 72b and the fourth wiring layer 74b have the same potential. For example, the ground pattern 78 formed in the second wiring layer 74a and a part of the conductive pattern formed in the first wiring layer 72a are electrically connected to each other through the via V2, and the ground pattern 78 formed in the fourth wiring layer 74b and a part of the conductive pattern formed in the third wiring layer 72b are electrically connected to each other through the via V3. In addition, a via V4 is implemented by a conductor penetrating from the first wiring layer 72a to the third wiring layer 72b, and conductive patterns electrically connected to the via V4 among the conductive patterns formed in the first wiring layer 72a and the third wiring layer 72b have the same potential. For example, a part of the conductive pattern formed in the first wiring layer 72a and a part of the conductive pattern formed in the third wiring layer 72b are electrically connected to each other through the via V4. Accordingly, a part of the conductive pattern of the first wiring layer 72a and a part of the conductive pattern of the third wiring layer 72b, and the ground pattern 78 of the second wiring layer 74a and the ground pattern 78 of the fourth wiring layer 74b that are connected thereto may be ground lines each having a common reference potential.

The wiring pattern 77 of the second wiring layer 74a and the wiring pattern 77 of the fourth wiring layer 74b are electrically connected to each other through the via V1. Accordingly, the electronic component mounted on the main surface 7a (main surface-side surface layer 71a) and the electronic component mounted on the sub surface 7b (sub surface-side surface layer 71b) may be electrically connected to each other.

The main surface-side surface layer 71a and the sub surface-side surface layer 71b are formed of, for example, a resist film, cover the second wiring layer 74a and the fourth wiring layer 74b, and protect the wiring patterns 77 from short-circuiting and the wiring pattern 77 and the ground pattern 78 from short-circuiting. The base layer 70, the main surface-side insulating layer 73a, and the sub surface-side insulating layer 73b are formed of, for example, an insulating material containing glass or epoxy resin, and are adhered while preventing short-circuiting between upper and lower layers.

### (Conductive Pattern Constituting VHEAT Line Ln6)

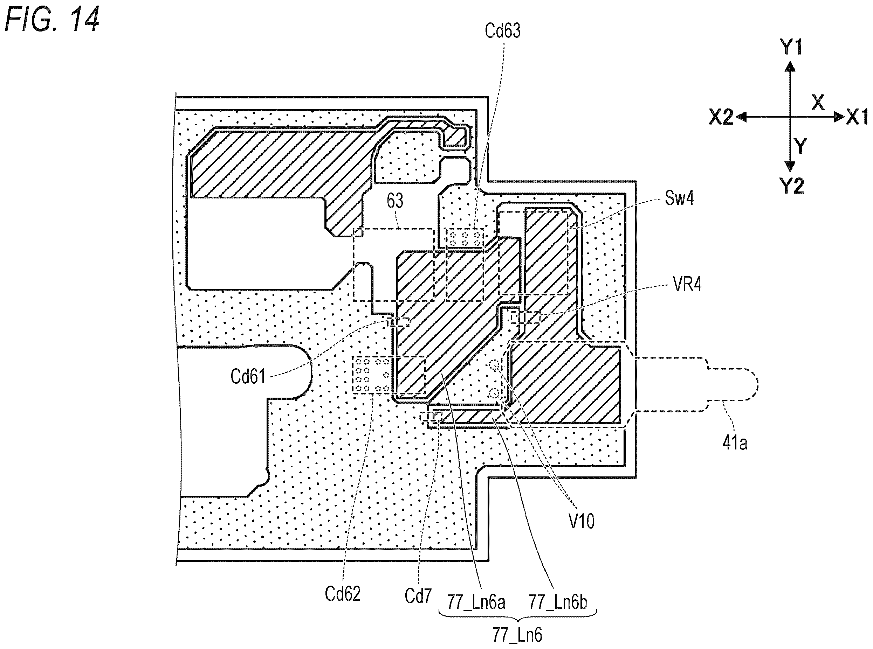

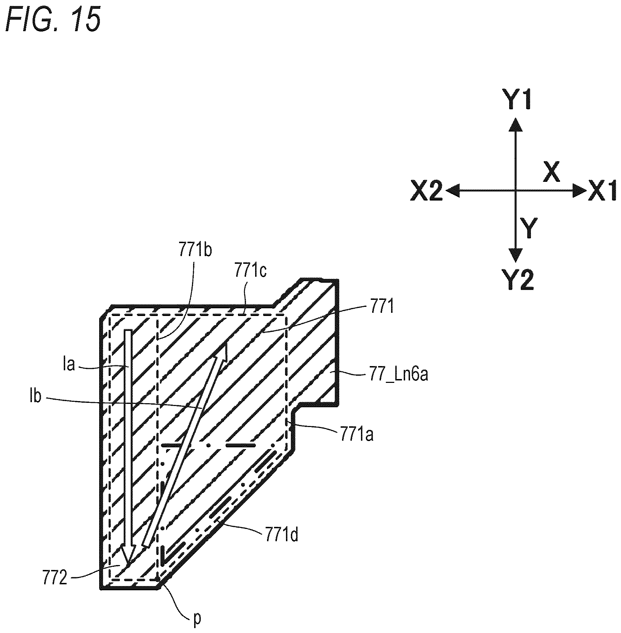

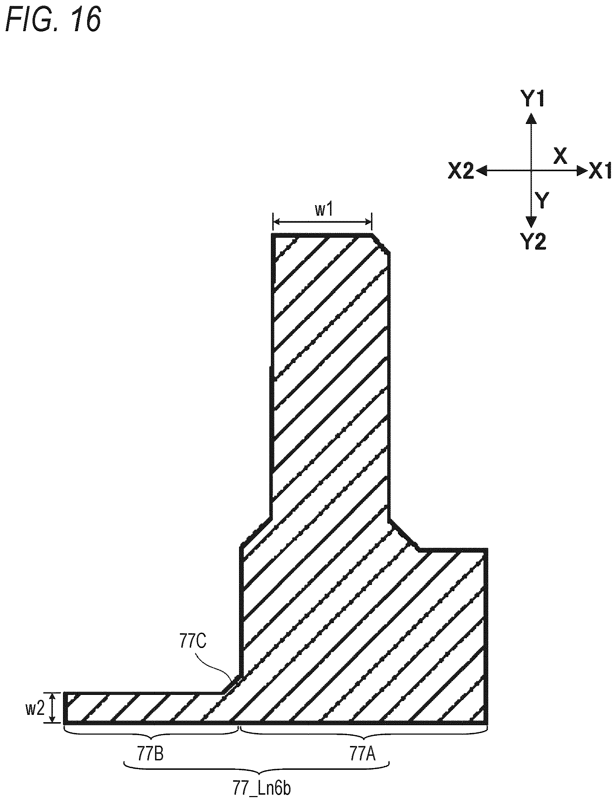

Next, the wiring pattern 77_Ln6 which is the conductive pattern constituting the VHEAT line Ln6 and the electronic components connected to the wiring pattern 77_Ln6 will be additionally described with reference to FIGs. 14 to 16. FIG. 14 is an enlarged view of the periphery of an end portion on an X1 direction side of the second wiring layer 74a of the MCU mounting substrate 7 shown in FIG. 9. In addition, FIG. 15 is an enlarged view of a wiring pattern 77_Ln6a shown in FIG. 14, and FIG. 16 is an enlarged view of a wiring pattern 77_Ln6b shown in FIG. 14.

In FIG. 14, broken lines denoted by reference signs indicate electronic components corresponding to the reference signs among the electronic components mounted on the main surface 7a (main surface-side surface layer 71a). Specifically, in FIG. 14, the broken line indicated by reference sign 63 indicates the DC-DC converter 63, the broken line indicated by reference sign Cd61 indicates the capacitor Cd61, the broken line indicated by reference sign Cd62 indicates the capacitor Cd62, the broken line indicated by reference sign Cd63 indicates the capacitor Cd63, the broken line indicated by reference sign Sw4 indicates the switch Sw4, the broken line indicated by reference sign Cd7 indicates the capacitor Cd7, the broken line indicated by reference sign VR4 indicates the varistor VR4, and the broken line indicated by reference sign 41a indicates the positive electrode-side discharge terminal 41a.

As shown in FIG. 14, the wiring pattern 77_Ln6 includes the wiring pattern 77_Ln6a to which the DC-DC converter 63, the capacitor Cd61, the capacitor Cd62, the capacitor Cd63, and the like are connected, and the wiring pattern 77_Ln6b to which the capacitor Cd7, the varistor VR4, the positive electrode-side discharge terminal 41a, and the like are connected. For example, the wiring pattern 77_Ln6a is a conductive pattern constituting a portion from the VOUT pin of the DC-DC converter 63 to the switch Sw4 in the VHEAT line Ln6 shown in FIG. 6. In addition, the wiring pattern 77_Ln6b is a conductive pattern constituting a portion from the switch Sw4 to the positive electrode-side discharge terminal 41a in the VHEAT line Ln6 shown in FIG. 6.

First, the wiring pattern 77_Ln6a to which the DC-DC converter 63, the capacitor Cd61, the capacitor Cd62, and the capacitor Cd63 are connected will be described. As shown in FIG. 15, the wiring pattern 77_Ln6a includes a trapezoidal portion 771 having a trapezoidal shape in the plan view of the MCU mounting substrate 7. The trapezoidal portion 771 has an upper base 771a, a lower base 771b having a length larger than that of the upper base 771a, a first leg 771c, and a second leg 771d having an angle with the lower base 771b smaller than that of the first leg 771c with the lower base 771b.

The VOUT pin of the DC-DC converter 63, one end (in other words, one terminal) of the capacitor Cd61, and one end (in other words, one terminal) of the capacitor Cd62 are respectively connected to predetermined portions on a lower base 771b side of the wiring pattern 77_Ln6a. In addition, the GND pin of the DC-DC converter 63, the other end (in other words, the other terminal) of the capacitor Cd61, and the other end (in other words, the other terminal) of the capacitor Cd62 are connected to the ground pattern 78. One end (in other words, one terminal) of the capacitor Cd63 is connected to a portion corresponding to the first leg 771c of the trapezoidal portion 771 in the wiring pattern 77_Ln6a, and the other end (in other words, the other terminal) of the capacitor Cd63 is connected to the ground pattern 78.

More specifically, as shown in FIG. 15, the wiring pattern 77_Ln6a has a substantially rectangular shape in the plan view of the MCU mounting substrate 7, and further includes a rectangular portion 772 connected to a connection point p between the lower base 771b and the second leg 771d and the lower base 771b. The VOUT pin of the DC-DC converter 63, the one end of the capacitor Cd61, and the one end of the capacitor Cd62 are respectively connected to portions corresponding to the rectangular portion 772. In addition, the capacitor Cd62 is disposed so as not to overlap the second leg 771d in the plan view of the MCU mounting substrate 7.

Therefore, current may flow from the DC-DC converter 63 to the capacitor Cd62, for example, as indicated by an arrow indicated by reference sign Ia in FIG. 15. Current may flow from the capacitor Cd62 to the capacitor Cd63, for example, as indicated by an arrow indicated by reference sign Ib in FIG. 15. Therefore, even when the DC-DC converter 63, the capacitor Cd61, the capacitor Cd62, and the capacitor Cd63 are arranged in the substantially L-shape, current may efficiently flow from the DC-DC converter 63 to the capacitor Cd63.

On the other hand, for example, a portion surrounded by a one-dot chain line in FIG. 15 is cut out, and a conductive pattern connecting the DC-DC converter 63, the capacitor Cd61, the capacitor Cd62, and the capacitor Cd63 is formed in a substantially L-shape in accordance with the arrangement of the capacitors. In this case, between the capacitor Cd62 and the capacitor Cd63, the current does not flow in a shortest path as indicated by the arrow indicated by the reference sign Ib, or even when the current flows in the shortest path, no sufficient thickness may be ensured in the path portion. As a result, an (apparent) electric resistance value of the conductive pattern connecting the DC-DC converter 63 to the capacitor Cd63 may increase, and the current may not efficiently flow from the DC-DC converter 63 to the capacitor Cd63. In addition, current flows so as to bend at a right angle through the substantially L-shaped conductive pattern, and thus noise or the like may be generated.

On the other hand, in the present embodiment, as described above, the wiring pattern 77_Ln6a includes the trapezoidal portion 771 and the rectangular portion 772 connected to the lower base 771b thereof, the DC-DC converter 63, the capacitor Cd61, and the capacitor Cd62 are connected to the rectangular portion 772, and the capacitor Cd63 is connected to the trapezoidal portion 771, and thus an increase in the (apparent) electric resistance value of the conductive pattern connecting the DC-DC converter 63 to the capacitor Cd63 may be avoided, and the current may efficiently flow from the DC-DC converter 63 to the capacitor Cd63.

In FIG. 14, each circle indicated by a broken line indicates a via. For example, in FIG. 14, vias in a region surrounded by the broken line indicated by the reference sign Cd62 are vias that connect the other end of the capacitor Cd62 and the ground (for example, the ground pattern 78 formed in the first wiring layer 72a). On the other hand, vias in a region surrounded by the broken line indicated by the reference sign Cd63 are vias that connect the other end of the capacitor Cd63 and the ground (for example, the ground pattern 78 formed in the first wiring layer 72a).

As shown in FIG. 14, for example, the number of vias (for example, 6) that connect the other end of the capacitor Cd63 to the ground is smaller than the number of vias (for example, 13) that connect the other end of the capacitor Cd62 to the ground. In other words, the number of vias that connect the other end of the capacitor Cd62 to the ground is larger than the number of vias that connect the other end of the capacitor Cd63 to the ground.

In general, as the number of vias connected to the ground increases, a smoothing effect of the capacitor is improved (stabilized). Therefore, by connecting the other end of the capacitor Cd62 to the ground using a large number of vias, the capacitor Cd62 may more effectively smooth an output voltage (fourth system voltage Vs4) of the DC-DC converter 63. Therefore, a more stable voltage may be supplied to the heater 21 that generates aerosol, and the heater 21 may stably generate the aerosol. Accordingly, it is possible to prevent deterioration of a fragrance taste of the aerosol inhalation device 1 due to unstable generation of the aerosol.

As shown in FIG. 14, the capacitor Cd63 is mounted on the MCU mounting substrate 7 so as to be closer to the switch Sw4 than the capacitor Cd62. In other words, the capacitor Cd62 connected to the ground using more vias than the capacitor Cd63 is mounted on the MCU mounting substrate 7 so as to be farther from the switch Sw4 than the capacitor Cd63.

That is, the capacitor Cd62 connected to the ground using more vias than the capacitor Cd63 smooths the output voltage of the DC-DC converter 63 more actively than the capacitor Cd63, and thus the capacitor Cd62 tends to generate heat. Therefore, by disposing the capacitor Cd62 farther from the switch Sw4 than the capacitor Cd63, the heat generated by the capacitor Cd62 is less likely to be transmitted to the switch Sw4, thereby stabilizing the operation of the switch Sw4. In addition, the heat generated by the capacitor Cd62 is less likely to be transmitted to the switch Sw4, and thus it is possible to prevent an increase in a temperature of the switch Sw4 and prevent an increase in ON resistance of the switch Sw4. Accordingly, an efficiency of supplying electric power to the heater 21 that generates the aerosol is improved, and the heater 21 may generate the aerosol with high efficiency.

It should be noted that FIG. 14 shows only some of the vias provided on the MCU mounting substrate 7.

Next, the wiring pattern 77_Ln 6b to which the capacitor Cd7, the varistor VR4, and the positive electrode-side discharge terminal 41a are connected will be described. As shown in FIG. 16, the wiring pattern 77_Ln6b includes a first conductive pattern 77A and a second conductive pattern 77B.

Referring also to FIG. 14, the first conductive pattern 77A extends along the lateral direction Y from a portion on which the switch Sw4 is mounted to a portion on which the positive electrode-side discharge terminal 41a is mounted, and may supply the fourth system voltage Vs4 to the positive electrode-side discharge terminal 41a. Considering that the fourth system voltage Vs4 is generated based on the output voltage of the power supply BAT, the first conductive pattern 77A may be referred to as (at least a part of) a conductive pattern that connects the power supply BAT and the positive electrode-side discharge terminal 41a. The switch Sw4, the varistor VR4, the positive electrode-side discharge terminal 41a, and the like are connected to the first conductive pattern 77A as electronic components.

The second conductive pattern 77B is branched from the first conductive pattern 77A. In the present embodiment, the second conductive pattern 77B is branched from a portion of the first conductive pattern 77A connected to the positive electrode-side discharge terminal 41a, and extends along the longitudinal direction X on a side (X2 direction side) opposite to the positive electrode-side discharge terminal 41a. For example, only the capacitor Cd7 is connected to the second conductive pattern 77B as an electronic component.

The capacitor Cd7 may function as a protection component for protecting the electronic components on the MCU mounting substrate 7 from noise (for example, static electricity generated in the positive electrode-side discharge terminal 41a, hereinafter also referred to as external noise) entering the power supply unit 10 through the positive electrode-side discharge terminal 41a. Specifically, the capacitor Cd7 is mounted on the MCU mounting substrate 7 such that one end (in other words, one terminal) is connected to the second conductive pattern 77B and the other end (in other words, the other terminal) is connected to the ground pattern 78 (that is, ground).

In this way, in the present embodiment, the second conductive pattern 77B branched from the first conductive pattern 77A that connects the power supply BAT and the positive electrode-side discharge terminal 41a is provided, and the one end of the capacitor Cd7, which is the protection component for protecting the electronic components on the MCU mounting substrate 7 from the external noise, is connected to the second conductive pattern 77B. Accordingly, at least a part of the external noise may be released from the first conductive pattern 77A to the second conductive pattern 77B, and thus the external noise flowing through the first conductive pattern 77A may be reduced, and the electronic components connected to the first conductive pattern 77A may be protected from the external noise.

Two or more electronic components (for example, three of the switch Sw4, the varistor VR4, and the positive electrode-side discharge terminal 41a) including the switch Sw4 and the positive electrode-side discharge terminal 41a are connected to the first conductive pattern 77A, whereas only the capacitor Cd7, which is the electronic component, is connected to the second conductive pattern 77B. In other words, the number of electronic components connected to the second conductive pattern 77B is smaller than the number of electronic components connected to the first conductive pattern 77A. Accordingly, the number of electronic components affected by the external noise may be reduced, as compared with a case in which a large number of electronic components are connected to the second conductive pattern 77B.

The second conductive pattern 77B is branched from the portion of the first conductive pattern 77A connected to the positive electrode-side discharge terminal 41a. Accordingly, the external noise is less likely to flow toward the first conductive pattern 77A, and thus the external noise flowing through the first conductive pattern 77A may be reduced, and the electronic components connected to the first conductive pattern 77A may be protected from the external noise.

As shown in FIG. 16, a chamfered portion 77C is provided at the portion at which the second conductive pattern 77B is branched from the first conductive pattern 77A (hereinafter, also simply referred to as a branch portion), and the branch portion does not have an angle of 90° or less (that is, does not form an acute angle). In a case where the branch portion is provided with a right-angled or acute-angled portion, noise may be generated when current flows through the corner portion. That is, in this case, noise other than the external noise may be further generated due to the interaction between a conductive pattern having a right-angled or acute-angled portion and the external noise flowing through the conductive pattern. Therefore, in the present embodiment, the branch portion does not have an angle of 90° or less, and thus the noise other than the external noise is prevented from being generated when the external noise flows to the second conductive pattern 77B. Instead of the chamfered portion 77C, for example, the branch portion may be formed in an arc shape so that the branch portion does not have an angle of 90° or less.

The second conductive pattern 77B is a conductive pattern having a dimension smaller than that of the first conductive pattern 77A. In the present embodiment, as shown in FIG. 16, a dimension of a thinnest portion of the first conductive pattern 77A is w1, and a dimension of a thinnest portion of the second conductive pattern 77B is w2 (w2 < w1). As described above, by making the second conductive pattern 77B have a dimension smaller than that of the first conductive pattern 77A, it is possible to reduce an area on the MCU mounting substrate 7 occupied by the second conductive pattern 77B, as compared with a case in which the second conductive pattern 77B has a dimension equal to or larger than that of the first conductive pattern 77A. Accordingly, the first conductive pattern 77A may be thickened while avoiding an increase in size of the MCU mounting substrate 7. If the first conductive pattern 77A is thickened, even when large current flows through the first conductive pattern 77A in order to ensure the amount of aerosol generated by the heater 21, it is possible to reduce heat or noise generated in the first conductive pattern 77A due to the large current.

The capacitor Cd7 has a rectangular shape with long sides and short sides in the plan view of the MCU mounting substrate 7. The capacitor Cd7 is mounted on the MCU mounting substrate 7 such that the long sides are parallel to the longitudinal direction X. That is, a length direction of the capacitor Cd7 coincides with the longitudinal direction X which is the extending direction of the case 11 (that is, the power supply unit 10 and the aerosol inhalation device 1). In this way, by mounting the capacitor Cd7 such that the length direction of the capacitor Cd7 coincides with the longitudinal direction X, it is possible to mount the capacitor Cd7 while avoiding an increase in a width dimension of the MCU mounting substrate 7, the power supply unit 10, or the aerosol inhalation device 1, as compared with a case in which the length direction of the capacitor Cd7 coincides with the lateral direction Y

The second conductive pattern 77B extends in the X2 direction, that is, in a direction away from the positive electrode-side discharge terminal 41a. That is, the positive electrode-side discharge terminal 41a itself is an electronic component that is not physically small, and a large number of components (for example, insulating components) generally tend to be provided around the positive electrode-side discharge terminal 41a. Therefore, the capacitor Cd7 may be less likely to be mounted near the positive electrode-side discharge terminal 41a. Therefore, by forming the second conductive pattern 77B to extend in the X2 direction, that is, in the direction away from the positive electrode-side discharge terminal 41a, the capacitor Cd7 may be mounted at a position away from the positive electrode-side discharge terminal 41a, and the capacitor Cd7 may be easily mounted.

As shown in FIG. 14, by connecting the capacitor Cd7 to an end portion on an X2 direction side of the second conductive pattern 77B, the capacitor Cd7 may be mounted at a position farther from the positive electrode-side discharge terminal 41a, and the capacitor Cd7 may be easily mounted.

As shown in FIG. 14, the varistor VR4, which is a protection component for protecting the electronic components on the MCU mounting substrate 7 from the external noise, is connected to the first conductive pattern 77A. Specifically, the varistor VR4 is mounted on the MCU mounting substrate 7 such that the one end (in other words, the one terminal) is connected to the first conductive pattern 77A and the other end (in other words, the other terminal) is connected to the ground pattern 78 (that is, ground). Accordingly, even when the external noise flows to the first conductive pattern 77A, the external noise may be released to the ground by the varistor VR4, and thus other electronic components connected to the first conductive pattern 77A may be protected from the external noise.

The varistor VR4 has a rectangular shape with long sides and short sides in the plan view of the MCU mounting substrate 7. The varistor VR4 is mounted on the MCU mounting substrate 7 such that the long sides are parallel to the longitudinal direction X. That is, a length direction of the varistor VR4 coincides with the longitudinal direction X which is the extending direction of the case 11 (that is, the power supply unit 10 and the aerosol inhalation device 1). In this way, by mounting the varistor VR4 such that the length direction of the varistor VR4 coincides with the longitudinal direction X, it is possible to mount the varistor VR4 while avoiding an increase in the width dimension of the MCU mounting substrate 7, the power supply unit 10, or the aerosol inhalation device 1, as compared with a case in which the length direction of the varistor VR4 coincides with the lateral direction Y

The switch Sw4, the varistor VR4, and the positive electrode-side discharge terminal 41a connected to the first conductive pattern 77A are arranged in a line on the first conductive pattern 77A. In the present embodiment, the first conductive pattern 77A extends along the lateral direction Y from the portion on which the switch Sw4 is mounted toward the portion on which the positive electrode-side discharge terminal 41a is mounted. The switch Sw4, the varistor VR4, and the positive electrode-side discharge terminal 41a are arranged on the first conductive pattern 77A in a state of being arranged in a line in the lateral direction Y (that is, the extending direction of the first conductive pattern 77A), each of which is connected to the first conductive pattern 77A. Accordingly, the first conductive pattern 77A may have a simple shape. Therefore, the first conductive pattern 77A may be formed to be thick as compared with a case in which the first conductive pattern 77A has a complicated shape for connecting the switch Sw4, the varistor VR4, and the positive electrode-side discharge terminal 41a. By forming the first conductive pattern 77A to be thick, it is possible to reduce the heat or the noise generated when the current flows through the first conductive pattern 77A.

The varistor VR4 is disposed between the switch Sw4 and the positive electrode-side discharge terminal 41a on the first conductive pattern 77A. Accordingly, even when the external noise flows to the first conductive pattern 77A, the switch Sw4 may be protected from the external noise by the varistor VR4. Therefore, it is possible to avoid failure of the switch Sw4 due to the external noise, and it is possible to avoid occurrence of unintended energization of the heater 21 due to the failure of the switch Sw4.

As shown in FIG. 14, a via V10 is provided in a space between the first conductive pattern 77A and the second conductive pattern 77B (in other words, a space adjacent to the first conductive pattern 77A and the second conductive pattern 77B). The via V10 is a via connected to the ground, specifically, a via connecting the ground pattern 78 in the first wiring layer 72a (and/or the third wiring layer 72b) and the ground pattern 78 in the second wiring layer 74a.

That is, when the external noise flows to the ground by the capacitor Cd7 or the varistor VR4, the ground may generate heat. Therefore, in the present embodiment, the via V10 connected to the ground (for example, the ground pattern 78 in the first wiring layer 72a) is provided between the first conductive pattern 77A and the second conductive pattern 77B, and the heat generated in the ground may be dissipated to the second wiring layer 74a close to the main surface 7a of the MCU mounting substrate 7 through the via V10. Accordingly, the MCU mounting substrate 7 may be efficiently cooled by reducing accumulation of the heat in the MCU mounting substrate 7 while effectively using the space between the first conductive pattern 77A and the second conductive pattern 77B to avoid an increase in size of the MCU mounting substrate 7.

As described above, according to the power supply unit 10 of the present embodiment, it is possible to avoid an increase in size of the MCU mounting substrate 7 and to downsize the MCU mounting substrate 7. By decreasing the size of the MCU mounting substrate 7, the power supply unit 10 including the MCU mounting substrate 7 may be downsized, the portability of the aerosol inhalation device 1 may be improved, and the convenience for the user may be improved. In addition, by downsizing the MCU mounting substrate 7, the cost for manufacturing the MCU mounting substrate 7 may also be decreased.

Although various embodiments of the present invention have been described above with reference to the drawings, it is needless to say that the present invention is not limited to the above-described examples. It is apparent to those skilled in the art that various modifications or corrections may be conceived within the scope described in the claims, and it is understood that the modifications or corrections naturally fall within the technical scope of the present invention.

For example, in the embodiment, an example has been described in which the heater 21 is a heating unit that consumes electric power supplied from the power supply BAT to generate aerosol from an aerosol source, and electric power is supplied from the discharge terminal 41 of the power supply unit 10 to the heater 21, but the present invention is not limited thereto. For example, the heating unit that generates the aerosol may include a susceptor built in the first cartridge 20 or the like and an induction heating coil that transmits electric power to the susceptor by electromagnetic induction. When the heating unit includes the susceptor and the induction heating coil, the discharge terminal 41 of the power supply unit 10 is connected to the induction heating coil and supplies electric power to the induction heating coil.

In the present specification, at least the following matters are described. In parentheses, corresponding constituent components and the like in the above-mentioned embodiment are indicated, but the present invention is not limited thereto.
(1) A power supply unit (power supply unit 10) of an aerosol generating device (aerosol inhalation device 1), including:
   a power supply (power supply BAT);
   a connector (discharge terminal 41) to which a load (heater 21) configured to generate aerosol from an aerosol source by consuming electric power supplied from the power supply, or a coil configured to transmit electric power to the load by electromagnetic induction is connected;
   a voltage converter (DC-DC converter 63) that has an input terminal (VIN pin) connected to the power supply and an output terminal (VOUT pin) connected to the connector;
   a first capacitor (capacitor Cd 63) and a second capacitor (capacitor Cd 61) connected between the output terminal of the voltage converter and the connector; and
   a circuit substrate (MCU mounting substrate 7) on which the voltage converter, the first capacitor, and the second capacitor are mounted, in which
   the first capacitor and the second capacitor are not arranged in a line in a length direction (longitudinal direction X) or a width direction (lateral direction Y) of the circuit substrate.

According to (1), the first capacitor and the second capacitor are not arranged in a line in the length direction or the width direction of the circuit substrate, and thus it is possible to avoid an increase in a length dimension and a width dimension of the circuit substrate as compared with a case in which these capacitors are arranged in a line. Accordingly, the circuit substrate may be downsized, and a cost for manufacturing the circuit substrate may be reduced.

(2) The power supply unit of the aerosol generating device according to (1), in which
the first capacitor is arranged in a line with the voltage converter in the length direction of the circuit substrate, and
the second capacitor is arranged in a line with the voltage converter in the width direction of the circuit substrate.

According to (2), the first capacitor and the second capacitor are not arranged in a line in the length direction and the width direction of the circuit substrate, and thus it is possible to avoid an increase in the length dimension and the width dimension of the circuit substrate as compared with the case in which these capacitors are arranged in a line.

(3) The power supply unit of the aerosol generating device according to (2), in which
the first capacitor has a capacitance larger than that of the second capacitor.

According to (3), by arranging the first capacitor, which tends to have a large capacitance and a large physical size, with the voltage converter in the length direction of the circuit substrate, it is possible to avoid an increase in the width dimension of the circuit substrate as compared with a case in which the first capacitor and the voltage converter are arranged in the width direction. Therefore, the circuit substrate may be downsized.

(4) The power supply unit of the aerosol generating device according to (3), further including:
a third capacitor (capacitor Cd 62) mounted on the circuit substrate, in which
the third capacitor is arranged in a line with the voltage converter and the second capacitor in the width direction of the circuit substrate, and
the third capacitor has a capacitance larger than that of the second capacitor.

According to (4), by arranging the third capacitor, which tends to have a large capacitance and a large physical size, with the voltage converter in the width direction, it is possible to avoid arranging the first capacitor and the third capacitor in the length direction or the width direction of the circuit substrate. Accordingly, it is possible to avoid an increase in the length dimension or the width dimension of the circuit substrate as compared with a case in which the first capacitor and the third capacitor are arranged in the length direction or the width direction. Therefore, the circuit substrate may be downsized.

(5) The power supply unit of the aerosol generating device according to (4), in which
the voltage converter, the second capacitor, and the third capacitor are arranged in a line in order of the voltage converter, the second capacitor, and the third capacitor in the width direction of the circuit substrate.

In the circuit substrate, a large number of vias or the like tend to be provided around the voltage converter. Therefore, a capacitor having a large capacitance and a large size such as the third capacitor is less likely to be mounted on the circuit substrate in the vicinity of the voltage converter. On the other hand, a capacitor having a small size such as the second capacitor is likely to be mounted on the circuit substrate in the vicinity of the voltage converter. According to (5), by arranging the voltage converter, the second capacitor, and the third capacitor in this order in the width direction of the circuit substrate, the voltage converter, the second capacitor, and the third capacitor may be mounted on the circuit substrate at high density, and a substrate area of the circuit substrate may be effectively used to downsize the circuit substrate.

(6) The power supply unit of the aerosol generating device according to (4) or (5), in which
the third capacitor has a rectangular shape with long sides and short sides, and
the long sides of the third capacitor are parallel to the length direction of the circuit substrate.

According to (6), the long sides of the third capacitor are parallel to the length direction of the circuit substrate, and thus even when the third capacitor is arranged with the voltage converter in the width direction of the circuit substrate, an increase in the width dimension of the circuit substrate may be prevented. Therefore, the circuit substrate may be downsized.

(7) The power supply unit of the aerosol generating device according to any one of (4) to (6), in which
one end of the first capacitor and one end of the third capacitor are connected to the output terminal of the voltage converter,
the other end of the first capacitor and the other end of the third capacitor are connected to a ground of the circuit substrate, and
the number of vias connecting the other end of the first capacitor to the ground is smaller than the number of vias connecting the other end of the third capacitor to the ground.

In general, as the number of vias connected to the ground increases, a smoothing effect of the capacitor is improved (stabilized). According to (7), by connecting the other end of the third capacitor to the ground using a large number of vias, the third capacitor may more effectively smooth an output voltage of the voltage converter. Therefore, a more stable voltage may be supplied to the load that generates the aerosol, and the load may stably generate the aerosol.

(8) The power supply unit of the aerosol generating device according to (7), further including:
a switch (switch Sw4) mounted on the circuit substrate and connected between the output terminal of the voltage converter and the connector, in which
the first capacitor is mounted on the circuit substrate so as to be closer to the switch than the third capacitor.

The third capacitor connected to the ground using more vias than the first capacitor smooths the output voltage of the voltage converter more actively than the first capacitor, and thus the third capacitor is likely to generate heat. According to (8), by disposing the third capacitor farther from the switch than the first capacitor, the heat generated by the third capacitor is less likely to be transmitted to the switch, thereby stabilizing the operation of the switch. In addition, the heat generated by the third capacitor is less likely to be transmitted to the switch, and thus it is possible to prevent an increase in a temperature of the switch and prevent an increase in ON resistance of the switch. Accordingly, an efficiency of supplying electric power to the load that generates the aerosol is improved, and the load may generate the aerosol with high efficiency.

(9) The power supply unit of the aerosol generating device according to any one of (2) to (8), in which
the first capacitor has a rectangular shape with long sides and short sides, and
the short sides of the first capacitor are parallel to the length direction of the circuit substrate.

According to (9), the short sides of the first capacitor are parallel to the length direction of the circuit substrate, and thus even when the first capacitor is arranged with the voltage converter in the length direction of the circuit substrate, an increase in the length dimension of the circuit substrate may be prevented. Therefore, the circuit substrate may be downsized.

(10) The power supply unit of the aerosol generating device according to any one of (2) to (9), in which
the number of capacitors mounted on the circuit substrate so as to be arranged in a line with the voltage converter in the length direction of the circuit substrate and connected to the output terminal of the voltage converter is smaller than the number of capacitors mounted on the circuit substrate so as to be arranged in a line with the voltage converter in the width direction of the circuit substrate and connected to the output terminal of the voltage converter.

According to (10), by setting the number of capacitors mounted on the circuit substrate so as to be arranged in a line with the voltage converter in the length direction of the circuit substrate to be smaller than the number of capacitors mounted on the circuit substrate so as to be arranged in a line with the voltage converter in the width direction of the circuit substrate, it is possible to avoid an increase in the length dimension of the circuit substrate and to decrease the size of the circuit substrate.

(11) The power supply unit of the aerosol generating device according to any one of (2) to (10), in which
the circuit substrate includes a conductive pattern to which the voltage converter, the first capacitor, and the second capacitor are connected,
the conductive pattern (wiring pattern 77_Ln6a) includes a trapezoidal portion having a trapezoidal shape,
the trapezoidal portion (trapezoidal portion 771) has an upper base (upper base 771a), a lower base (lower base 771b) having a length larger than that of the upper base, a first leg (first leg 771c), and a second leg (second leg 771d) having an angle with the lower base smaller than that of the first leg with the lower base,
the voltage converter and the second capacitor are connected to a lower base side, and
the first capacitor is connected to the first leg.

(12) The power supply unit of the aerosol generating device according to (11), in which
the conductive pattern has a substantially rectangular shape and further includes a rectangular portion (rectangular portion 772) connected to a connection point (connection point P) between the lower base and the second leg and the lower base, and
the voltage converter and the second capacitor are connected to the rectangular portion.

According to (12), the conductive pattern to which the voltage converter, the first capacitor, and the second capacitor are connected does not have an acute angle, and thus it is possible to reduce an increase in the electric resistance value of the conductive pattern and heat or noise generated from the conductive pattern.

(13) The power supply unit of the aerosol generating device according to (11) or (12), in which
the first capacitor does not overlap the second leg in a plan view of the circuit substrate.

[0226] According to (11), the conductive pattern between the first capacitor and the second capacitor may be thickened, and thus it is possible to avoid an increase in an electric resistance value of the conductive pattern to which the voltage converter, the first capacitor, and the second capacitor are connected. Accordingly, even when the first capacitor and the second capacitor are mounted on the circuit substrate so as not to be arranged in a line in the length direction and the width direction of the circuit substrate, current may efficiently flow between the first capacitor and the second capacitor, and the voltage converter.

According to (13), the conductive pattern between the first capacitor and the second capacitor may be thickened, and thus it is possible to avoid an increase in the electric resistance value of the conductive pattern to which the voltage converter, the first capacitor, and the second capacitor are connected. Accordingly, even when the first capacitor and the second capacitor are mounted on the circuit substrate so as not to be arranged in a line in the length direction and the width direction of the circuit substrate, current may efficiently flow between the first capacitor and the second capacitor, and the voltage converter.

### REFERENCE SIGNS LIST

1: aerosol inhalation device (aerosol generating device)
7: MCU mounting substrate (circuit substrate)
10: power supply unit
21: heater (load)
41: discharge terminal (connector)
63: DC-DC converter (voltage converter)
BAT: power supply
Cd61: capacitor (second capacitor)
Cd62: capacitor (third capacitor)
Cd63: capacitor (first capacitor)
X: longitudinal direction (length direction)
Y: lateral direction (width direction)

## Claims

1. A power supply unit of an aerosol generating device, comprising:
a power supply;
a connector to which a load configured to generate aerosol from an aerosol source by consuming electric power supplied from the power supply, or a coil configured to transmit electric power to the load by electromagnetic induction is connected;
a voltage converter that has an input terminal connected to the power supply and an output terminal connected to the connector;
a first capacitor and a second capacitor connected between the output terminal of the voltage converter and the connector; and
a circuit substrate on which the voltage converter, the first capacitor, and the second capacitor are mounted, wherein
the first capacitor and the second capacitor are not arranged in a line in a length direction or a width direction of the circuit substrate.

2. The power supply unit of the aerosol generating device according to claim 1, wherein
the first capacitor is arranged in a line with the voltage converter in the length direction of the circuit substrate, and
the second capacitor is arranged in a line with the voltage converter in the width direction of the circuit substrate.

3. The power supply unit of the aerosol generating device according to claim 2, wherein
the first capacitor has a capacitance larger than that of the second capacitor.

4. The power supply unit of the aerosol generating device according to claim 3, further comprising:
a third capacitor mounted on the circuit substrate, wherein
the third capacitor is arranged in a line with the voltage converter and the second capacitor in the width direction of the circuit substrate, and
the third capacitor has a capacitance larger than that of the second capacitor.

5. The power supply unit of the aerosol generating device according to claim 4, wherein
the voltage converter, the second capacitor, and the third capacitor are arranged in a line in order of the voltage converter, the second capacitor, and the third capacitor in the width direction of the circuit substrate.

6. The power supply unit of the aerosol generating device according to claim 4 or 5, wherein
the third capacitor has a rectangular shape with long sides and short sides, and
the long sides of the third capacitor are parallel to the length direction of the circuit substrate.

7. The power supply unit of the aerosol generating device according to any one of claims 4 to 6, wherein
one end of the first capacitor and one end of the third capacitor are connected to the output terminal of the voltage converter,
the other end of the first capacitor and the other end of the third capacitor are connected to a ground of the circuit substrate, and
the number of vias connecting the other end of the first capacitor to the ground is smaller than the number of vias connecting the other end of the third capacitor to the ground.

8. The power supply unit of the aerosol generating device according to claim 7, further comprising:
a switch mounted on the circuit substrate and connected between the output terminal of the voltage converter and the connector, wherein
the first capacitor is mounted on the circuit substrate so as to be closer to the switch than the third capacitor.

9. The power supply unit of the aerosol generating device according to any one of claims 2 to 8, wherein
the first capacitor has a rectangular shape with long sides and short sides, and
the short sides of the first capacitor are parallel to the length direction of the circuit substrate.

10. The power supply unit of the aerosol generating device according to any one of claims 2 to 9, wherein
the number of capacitors mounted on the circuit substrate so as to be arranged in a line with the voltage converter in the length direction of the circuit substrate and connected to the output terminal of the voltage converter is smaller than the number of capacitors mounted on the circuit substrate so as to be arranged in a line with the voltage converter in the width direction of the circuit substrate and connected to the output terminal of the voltage converter.

11. The power supply unit of the aerosol generating device according to any one of claims 2 to 10, wherein
the circuit substrate includes a conductive pattern to which the voltage converter, the first capacitor, and the second capacitor are connected,
the conductive pattern includes a trapezoidal portion having a trapezoidal shape,
the trapezoidal portion has an upper base, a lower base having a length larger than that of the upper base, a first leg, and a second leg having an angle with the lower base smaller than that of the first leg with the lower base,
the voltage converter and the second capacitor are connected to a lower base side, and
the first capacitor is connected to the first leg.

12. The power supply unit of the aerosol generating device according to claim 11, wherein
the conductive pattern has a substantially rectangular shape and further includes a rectangular portion connected to a connection point between the lower base and the second leg and the lower base, and
the voltage converter and the second capacitor are connected to the rectangular portion.

13. The power supply unit of the aerosol generating device according to claim 11 or 12, wherein
the first capacitor does not overlap the second leg in a plan view of the circuit substrate.
